(19) Europäisches Patentamt
European Patent Office
Office européen des brevets

(11) Publication number: 0 247 988 A2

# (12) EUROPEAN PATENT APPLICATION

(21) Application number: 87850173.3

(22) Date of filing: 22.05.87

(51) Int. Cl.4: H 05 K 7/14

(30) Priority: 28.05.86 US 868391

(43) Date of publication of application: 02.12.87 Bulletin 87/49

(84) Designated Contracting States: AT BE CH DE ES FR GB GR IT LI LU NL SE

(71) Applicant: ADC TELECOMMUNICATIONS, INC.
5501 Green Valley Drive
Bloomington Minnesota 55437 (US)

(72) Inventor: Werdin, David A.
1864 Marshall Avenue
St. Paul, MN 55104 (US)

Henke, Reinhold
917 Osceloa Avenue
St. Paul, MN 55105 (US)

(74) Representative: Rostovanyi, Peter et al
AWAPATENT AB Box 5117
S-200 71 Malmö (SE)

## (54) Low RF emission fiber optic transmission system.

(57) An electrical to fiber optic conversion unit for use in a fiber optic transmission link includes a ferrous metal chassis with an open front end for receiving a plurality of conversion modules and power supply or test modules. The conversion module includes circuitry for converting electrical signals to fiber optic signals and is constructed of a multi-layer printed circuit board having top and bottom layers substantially covered with a non-current conducting chassis ground. The several internal layers of the conversion PC board include two signal layers for interconnecting components on the board, with the signal layers being separated by a power distribution layer and a interconnect layer for connecting components on opposite ends of the board. The multi-layer PC construction suppresses RF noise from the conversion module providing that the front panel of the module may be left uncovered while still achieving very low levels of RF emission.

FIG. I
120
22
10
16
111
111
107
30
12
64
14
100
14
60
16
62
20
69

EP 0 247 988 A2

## Description

# LOW RF EMISSION FIBER OPTIC TRANSMISSION SYSTEM

### Technical Field of the Invention

The present invention relates generally to the field of telecommunications and more particularly to the art of electrical to optical conversion and fiber optic transmission in low RF emission standards environments.

### Background of the Invention

Fiber optic transmission of sensitive information is now widely used by security-conscious government and military agencies because of the extremely low RF emission characteristics and resistance to tapping of fiber optics as compared to conventional copper connections. The conversion interface of the wired connections with the fiber optic system remains, however, a source of RF radiation which must be carefully controlled in order to assure adequate data security. Accordingly, organizations like the National Security Agency (NSA) require interface equipment to meet stringent RF emission standards, for instance the TEMPEST requirements.

In the past, the conventional approach to achieving very low levels of RF emmissions from a conversion interface has been one of containment, wherein the interface unit is totally enclosed to prevent RF radiation from escaping. This strategy has generally required that the front end and front access panels of the unit be sealed closed with a cover using RF gaskets. Thus, accessing the front panels of the interface circuitry has required that the cover be removed, resulting in undesirable RF emission while the unit is open. Furthermore, it is known to often happen that technicians fail to properly resecure the cover after front panel access, resulting in a loss of compliance with the desired standards, and a possible security compromise.

### Summary of the Invention

The present invention departs from the prior art strategy to provide a low RF emission conversion unit which provides an uncovered front panel while maintaining low RF emmission characteristics. To do so, the present invention combines an emission supression strategy in the internal circuit modules with a modified conventional containment strategy, thus allowing for the desired unimpeded front panel access for testing, monitoring and repair without the substantial loss of data security incumbent with prior art designs.

With respect to the particulars of the present invention, there is provided a unit housing having an open front end for receiving modules for data conversion, testing or power supply. The rear and sides of the housing are constructed of ferrous metal for emissions containment. Each of the modules mounted in the housing includes a front panel also constructed of ferrous material, and are sized to fit snugly against adjacent panels, whereby a substantially continuous emission containment front cover is provided by the panels mounted accross the front end of the housing.

In order to minimize RF emission from the internal circuitry, the data handling modules comprise multilayer printed circuit boards which provide that the most prevalent sources of RF emission are sandwiched between layers including substantial ground plane surface area and that long signal runs are also substantially surrounded by ground plane. Moreover, the module power planes are provided with independent ground returns to minimize coupling with other ground connections, whereby the crosstalk and antenna effects are reduced.

Thus, the present invention combines an RF emission suppression strategy with conventional containment strategies to allow for an uncovered front panel which has heretofore not been considered feasible. These and other salient aspects of the invention, together with the other more subtle aspects thereof will be discussed in more detail below with respect to the drawings.

### Brief Description of the Drawings

Figures I-8 show the conversion unit chassis and module arrangement according to the present invention;

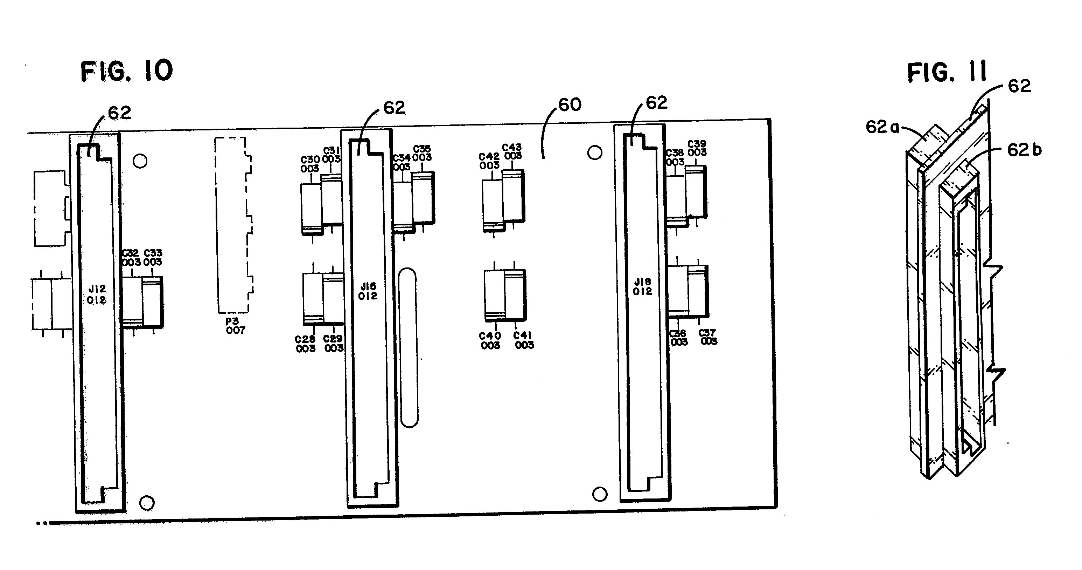

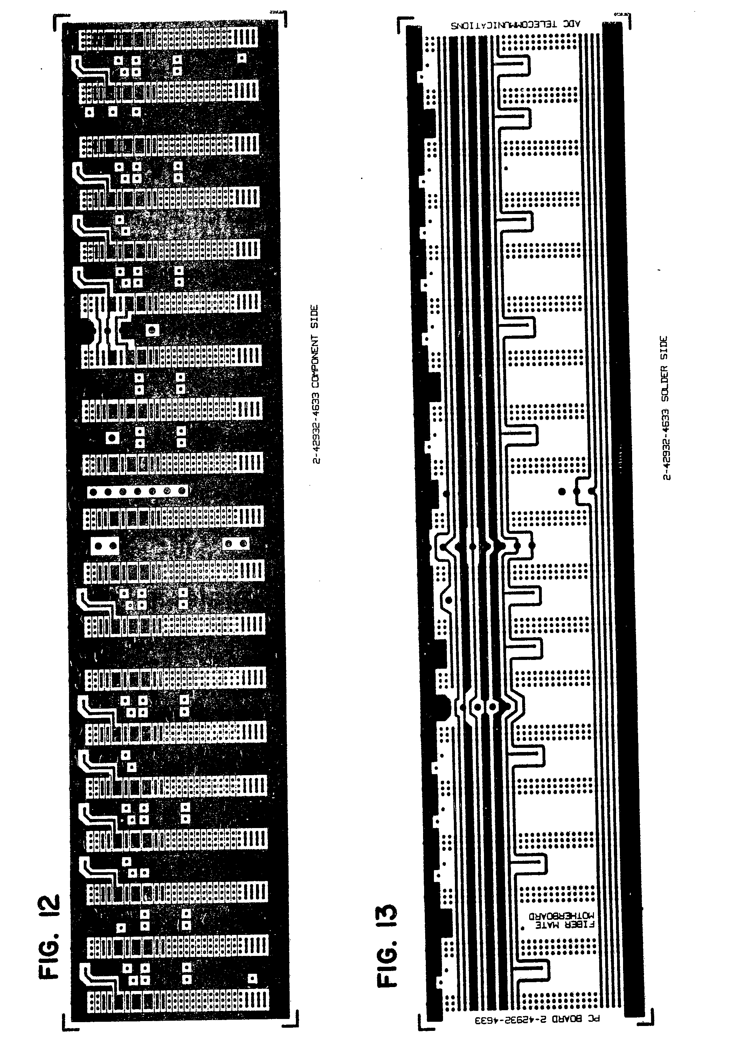

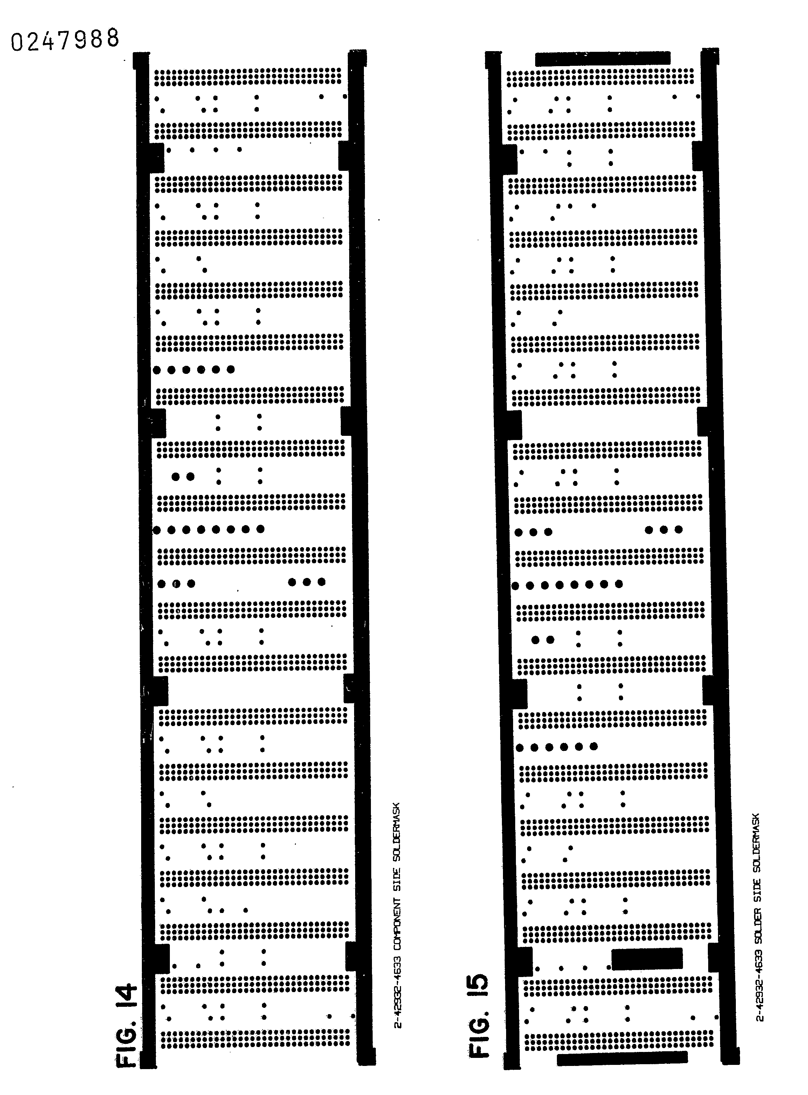

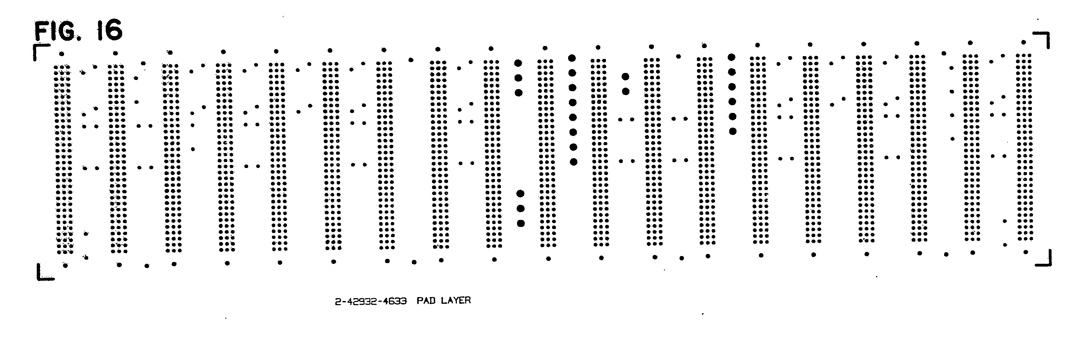

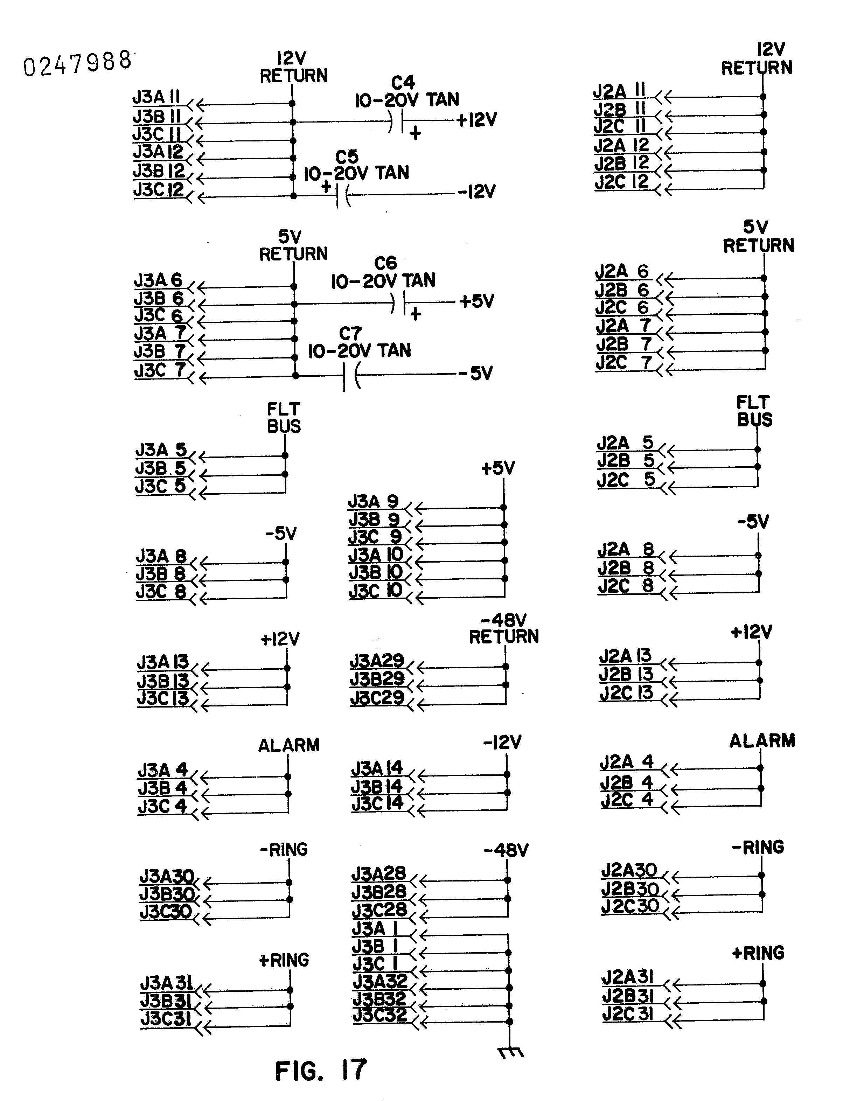

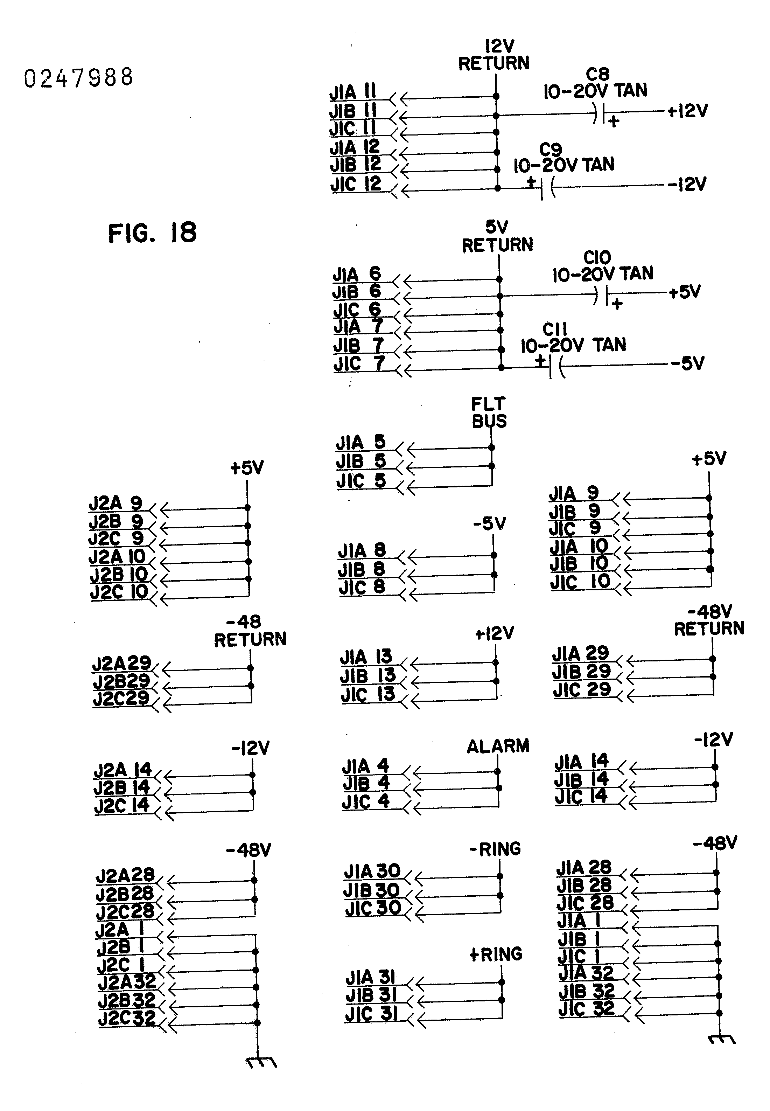

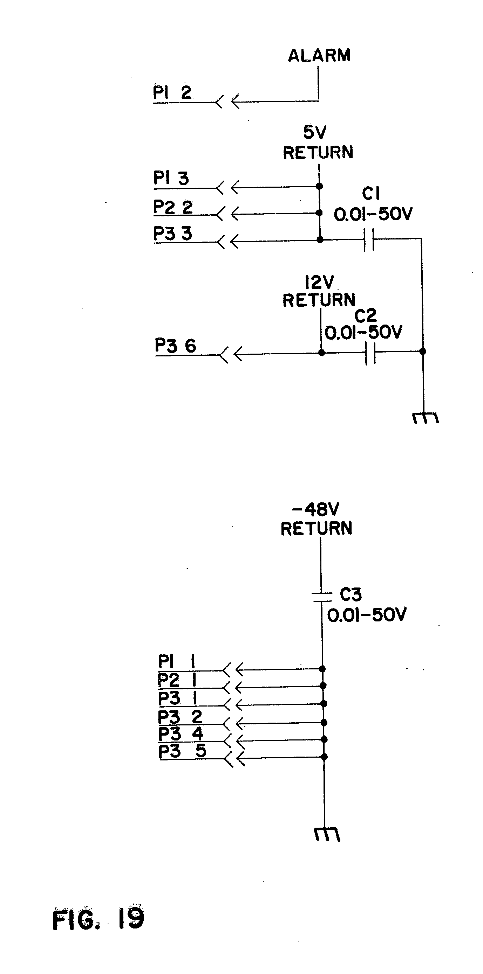

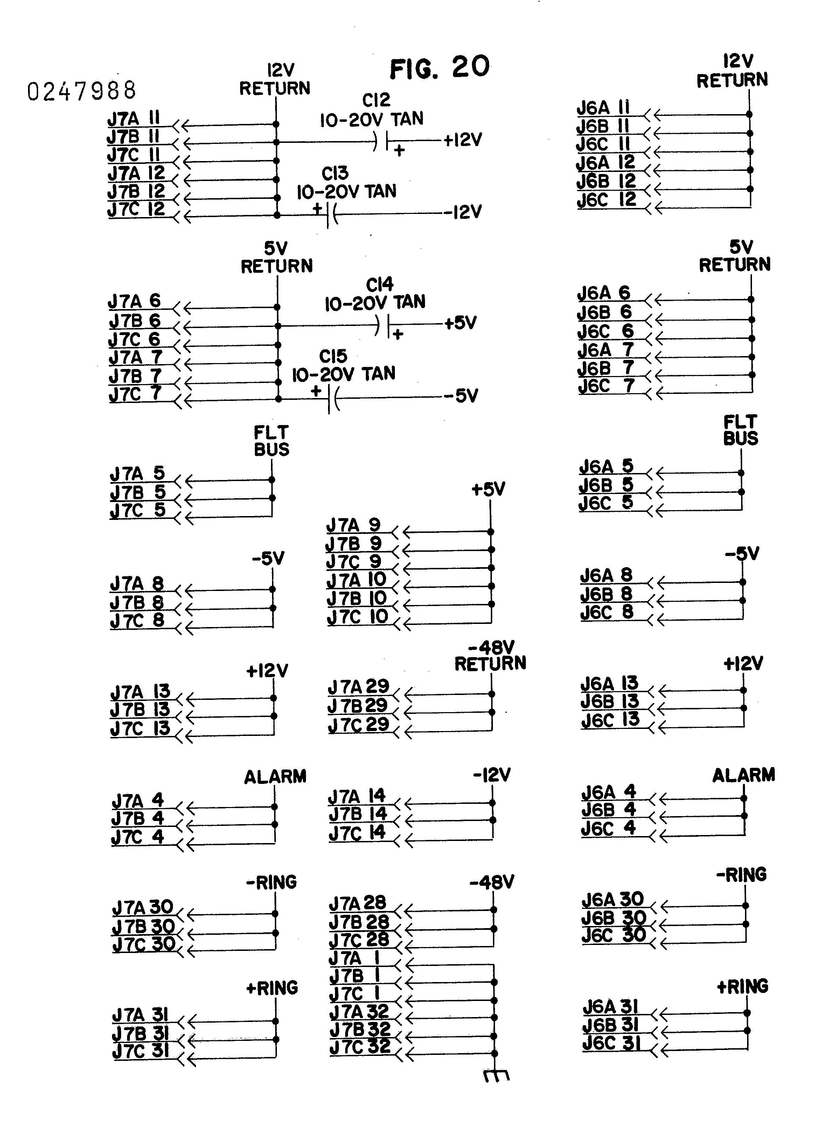

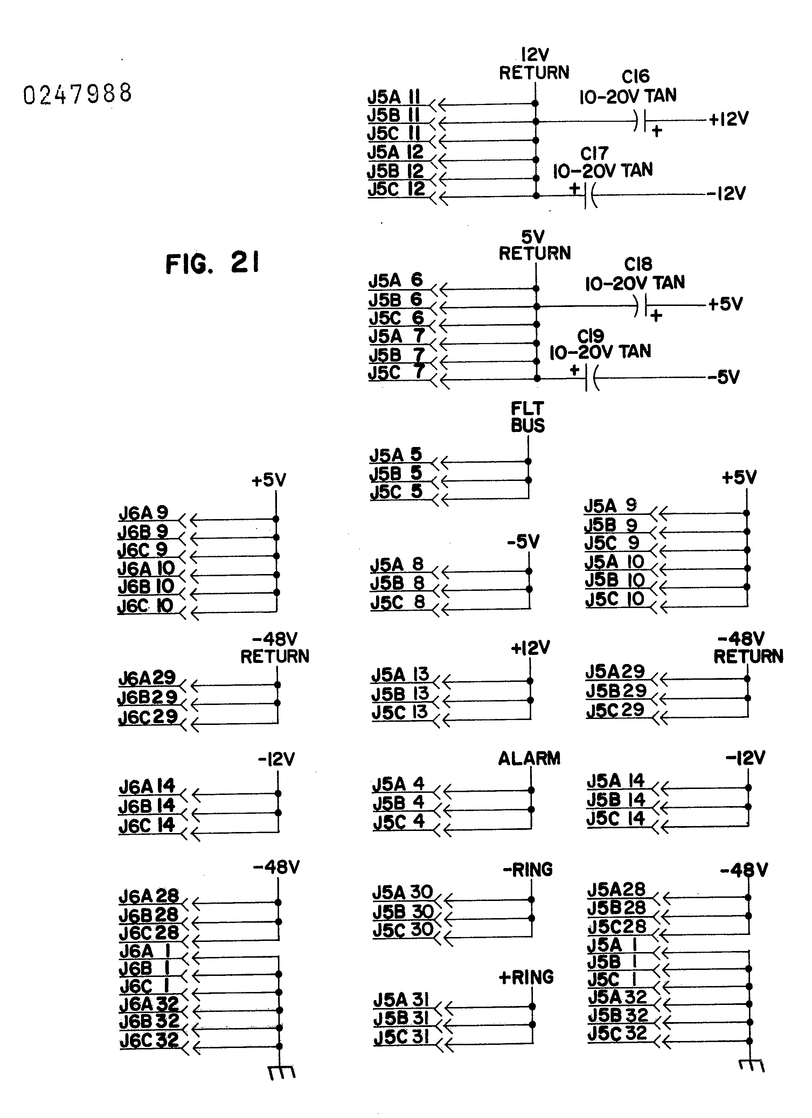

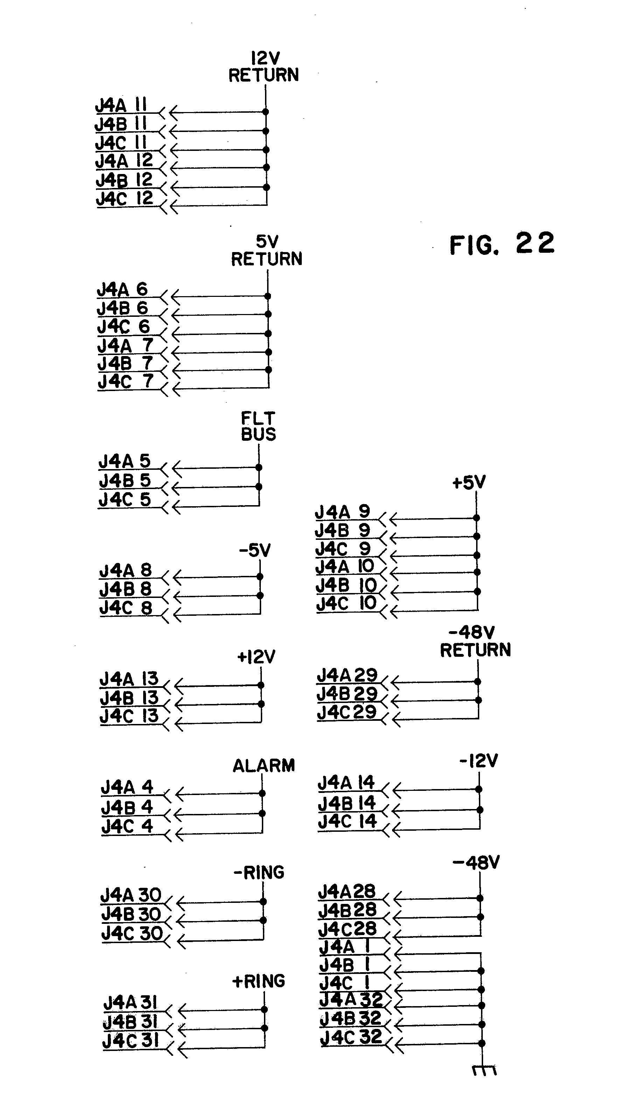

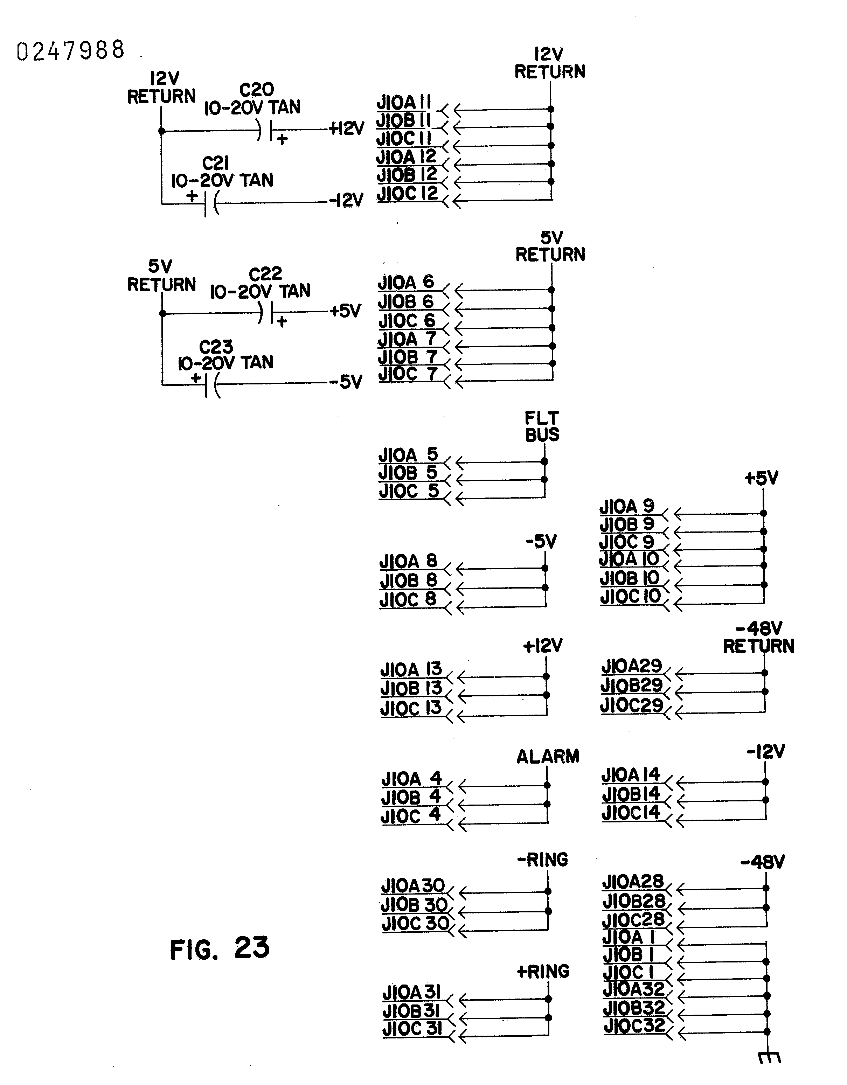

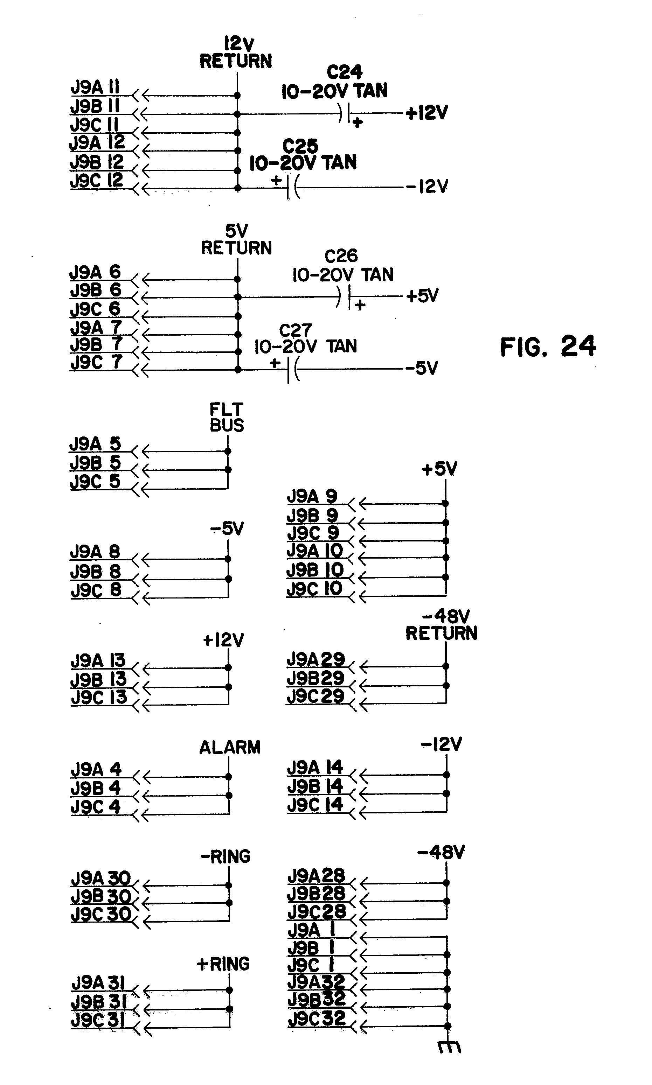

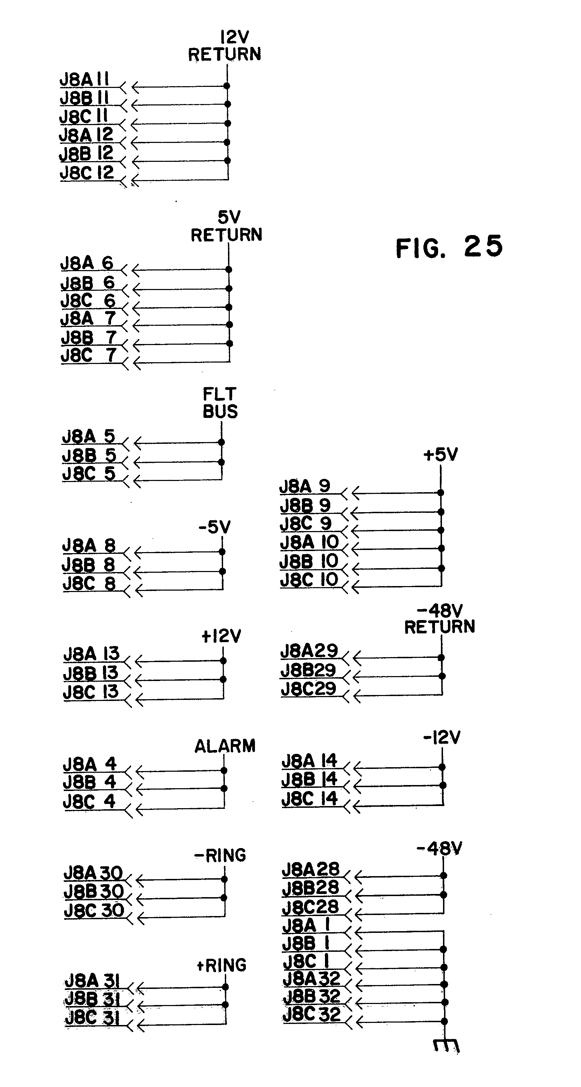

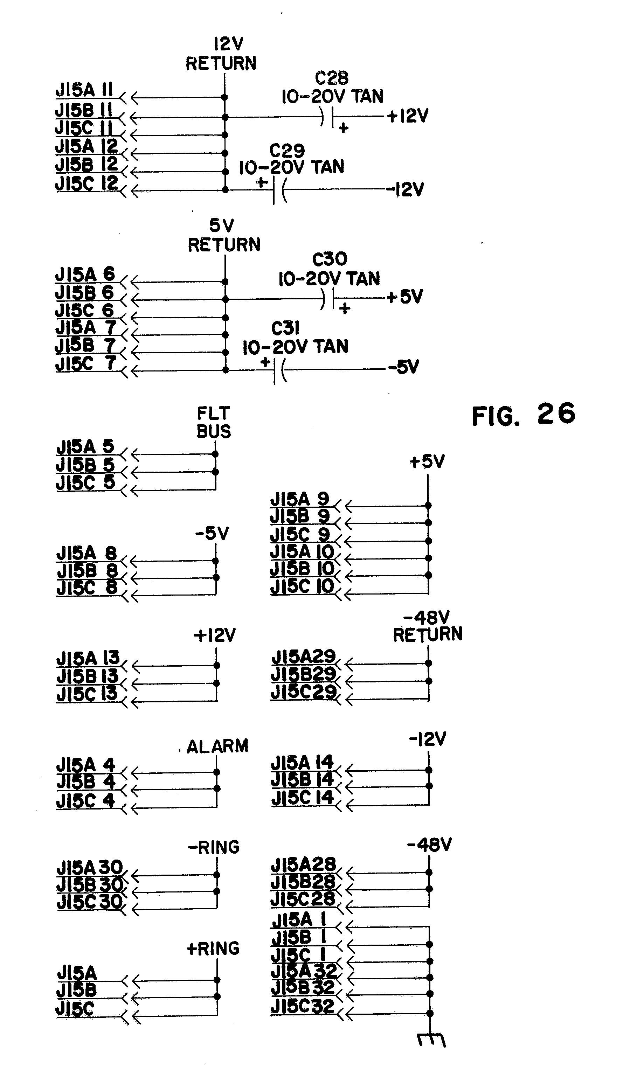

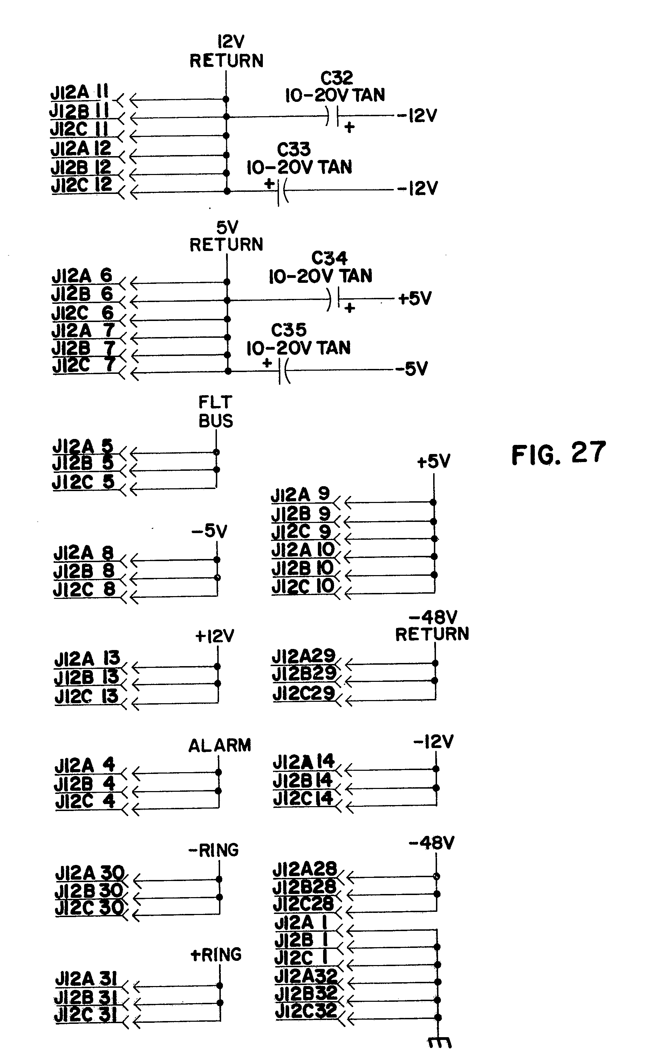

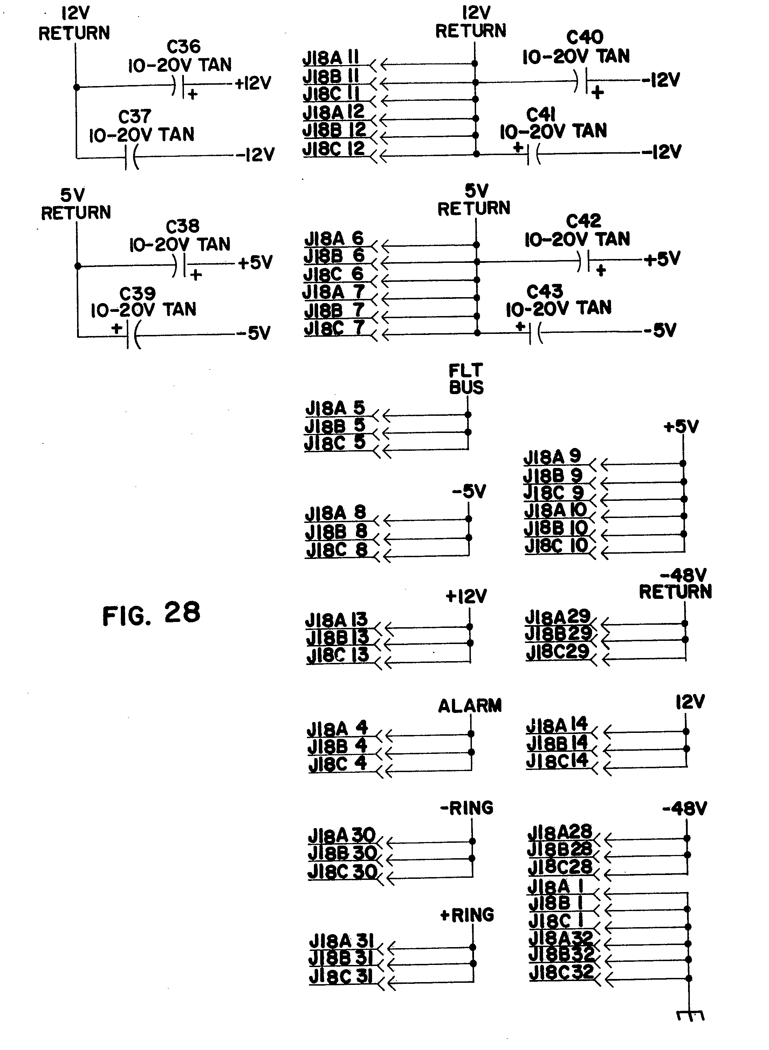

Figures 9-28 illustrate the construction of the motherboard according to the present invention;

Figure 29 is an electrical schematic diagram of the low speed channel multiplexer according to the present invention;

Figures 30-4I show the electrical schematic diagram of the low speed channel multiplexer according to the present invention;

Figures 42A-D show the component layout and assembly of a multiplexing module according to the present invention;

Figures 43-49 show the Mylar sheets for the various labels of the circuit board of the multiplexer module according to the present invention; and

Figures 50-52 illustrate the test module according to the present invention.

### Detailed Description of the Invention

The present invention provides a fiber optic transmission link between electrical input/output (I/O) equipment. The typical use for such equipment is in government and military installations where RF radiation is sought to be minimized in order to reduce or eliminate the likelihood that data transmissions may be intercepted by adverse intelligence organizations. The present invention thus provides for converting electrical signals, for example as taken from a MIL-I88, RS 232, RS 422 or RS 423 interface, and converting or encoding them to optical pulses which may be transmitted over low RF emission fiber optic links, which additionally have the benefit of being fairly tap-resistant. Thus, the electrical/fiber optic aspect of the present invention basically comprises data encoder/decoder conversion circuitry interfacing with the electrical cables on either end of the fiber optic link, which may thus be run from one end of a building to another, or from building to building in an installation or compound.

Although the fiber optic link itself is relatively low in RF emission, the interface between the link and the electrical cables, which are typically shielded to guard against RF radiation, must be carefully handled or it becomes a significant source of RF emission itself. As mentioned above in the Background section hereof, the prior art approach to the problem of the interface unit has been to contain the RF emission by encasing essentially the entire interface, encoder/decoder conversion circuits and all in a sealed ferrous metal container. However, as also mentioned above, this is problematic in terms of accessing the various circuits and lines for monitoring, repair or testing. The present invention, on the other hand, has incorporated a signal suppression approach with a modified containment strategy in order to provide unfettered front panel access.

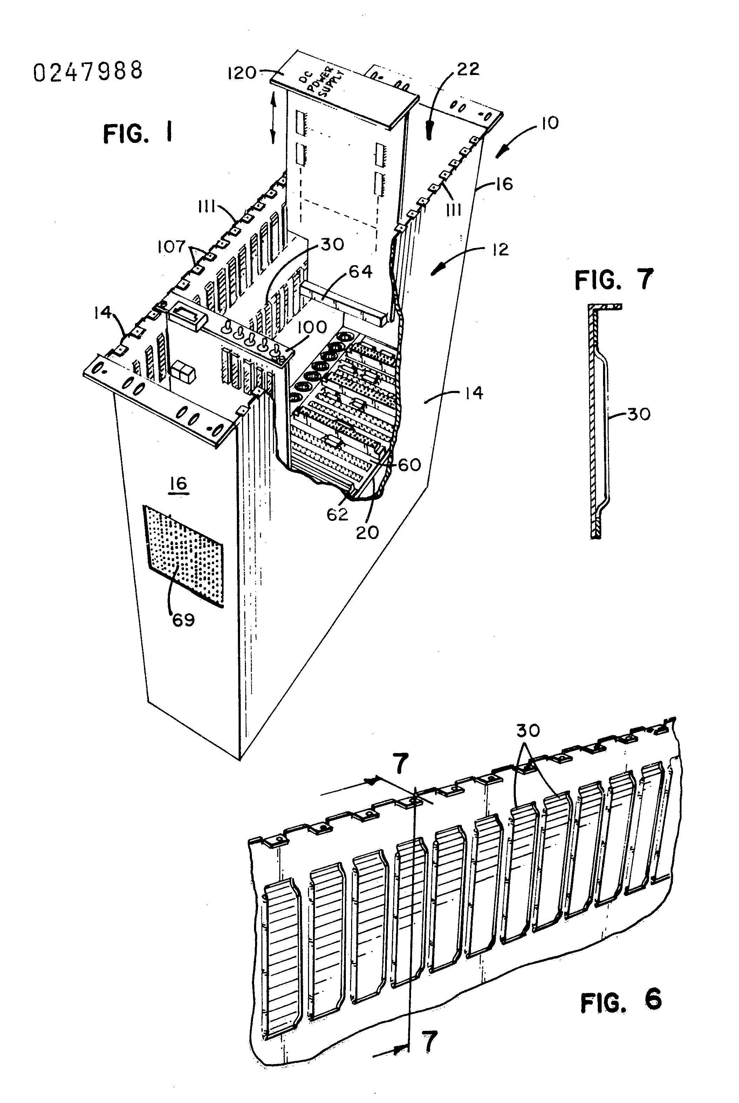

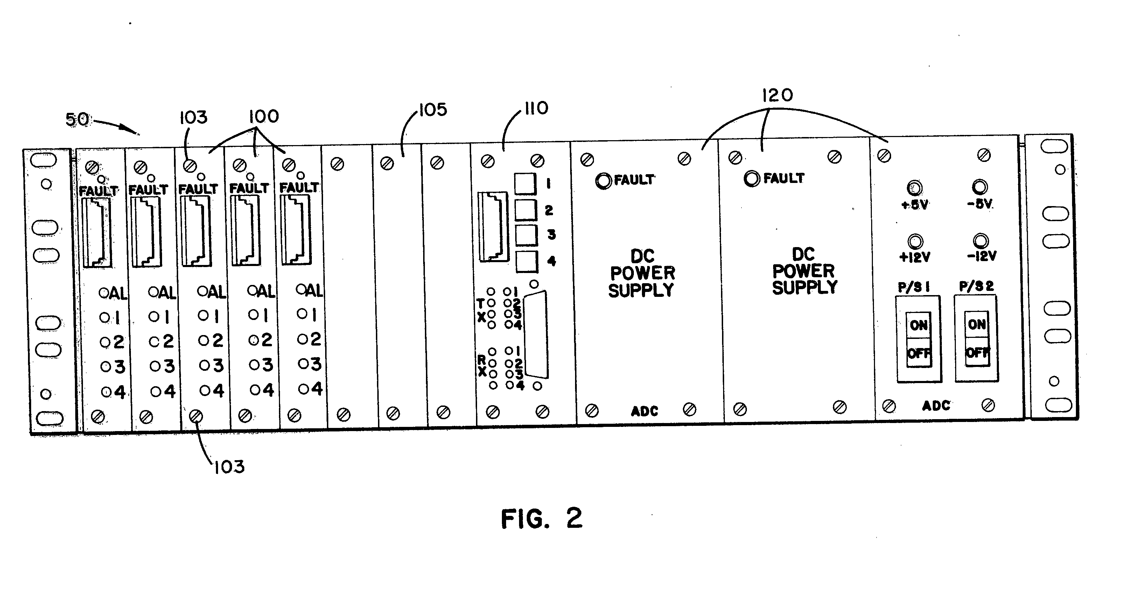

Referring now to Figures I through 7 the overall aspects of the invention will be described. In Figure I there is shown a perspective view of the interface/ conversion unit I0. The interface unit I0 includes a housing/chassis I2 having top and bottom walls I4 and sidewalls I6. An internal rear panel 20 is mounted to extend across the rear end of the chassis in order to generally define a signal containment area 22. The rear panel and walls of unit I0 are preferably formed from heavy .060 to .075 inch[e] zinc or zinc chromate plated cold rolled ferrous steel. The front end of area 22 is covered by the various front panels of card modules 50, or with blanks, as may be seen with respect to the front view of Figure 2.

As may be seen best with respect to Figures I, 3, 6 and 7, the chassis I2 includes a plurality of card guides 30 which are formed from a single sheet of sheet metal and fixed to the top and bottom walls I4 to provide cooperating guides. As may be seen with respect to Figure I, a card module 50 may thus be mounted in the chassis I2 by sliding it in. As will be explained in more detail below each card module 50 comprises a printed circuit board mounted to a sheet metal support of rougly the same outline so that the sheet metal support slides in the card guides. The front panels of each of card modules 50 are spot welded to the metal support, and the printed circuit boards are mounted to the support with metal stand-offs.

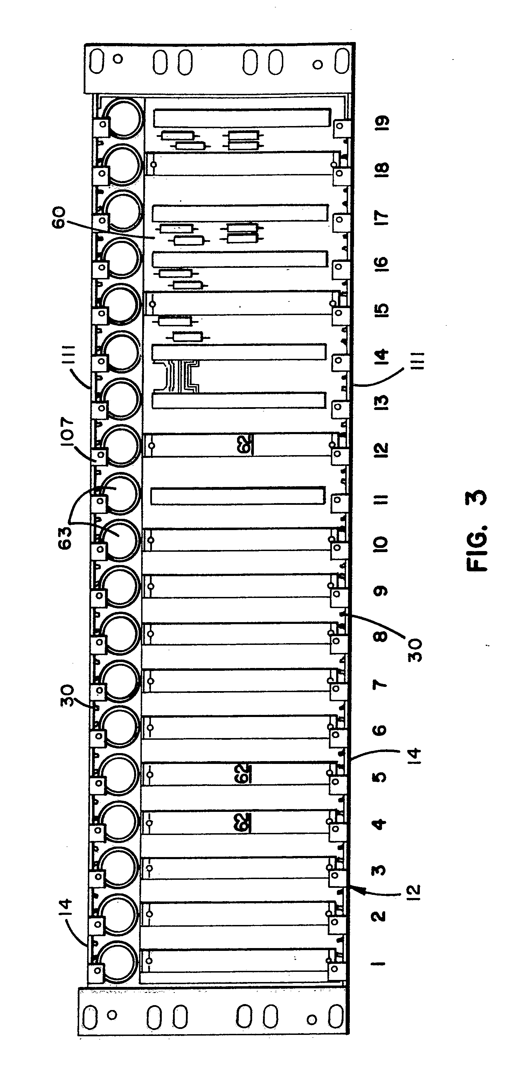

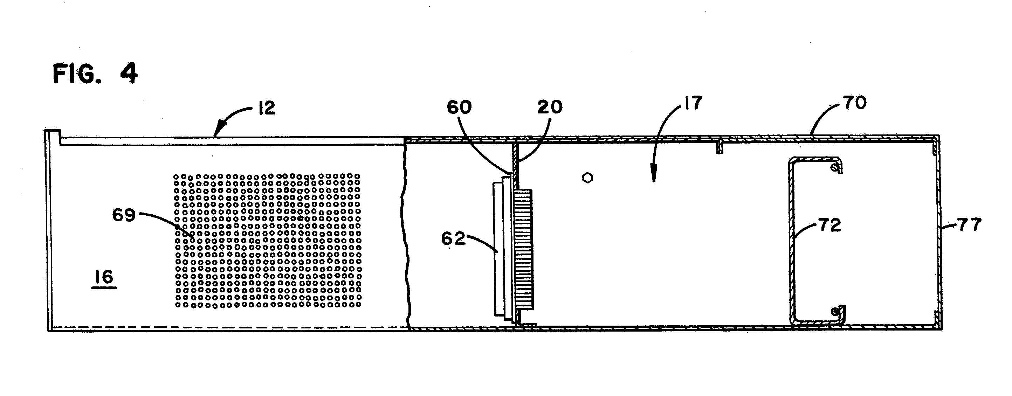

As may be generally seen with respect to Figures 3 and 4, the internal rear panel 20 supports a motherboard 60, which includes a plurality of connectors 62 for receiving a mating DIN connector 64 of the modules 50. Motherboard 60 provides for power bus supply to the modules 50 and any other necessary bussing or connection between modules. Thus, a module inserted in the chassis I2 mates with a corresponding slot in the motherboard 60.

As may be seen with respect to Figure 4, the connectors 62 extend through panel 20 to provide a contact or connection point outside. the containment area in the rear area I7 of the chassis I2. Thus, electrical cables may be connected to the modules by connection to the exposed side of connectors 62, which, where the connectors need to be connected to outside data lines are preferably 96 Pin DIN connectors with a male having long tails. Otherwise, connectors 62 may be female DIN connectors, as for instance is used in the case of the power supply module slots.

As may be seen in Figure 3, rear panel 20 preferably includes a plurality of fiber optic cable openings 63 through which the fiber optic link cables may be run to and from conversion circuit modules. Furthermore, as may be seen in Figures I, 4 and 5, the chassis I2 includes a plurality of vent holes which are also designed to allow for cooling of the unit while inhibiting RF emission, as is conventionally done. For this purpose is has been found desirable to use double thick walls to achieve vent-hole dimensions sufficient to filter high frequencies.

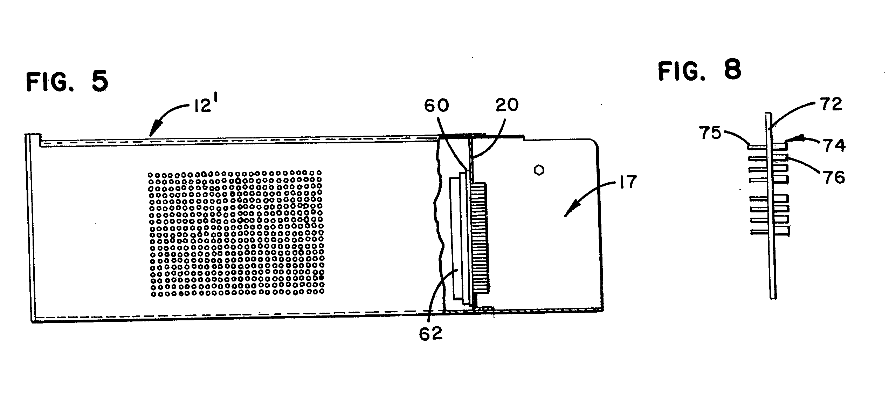

The embodiment of the chassis I2 shown in Figure I and 4 includes an enclosed extension 70, within which there is mounted a quick connect panel 72. As shown in Figure 8, panel 72 carries a plurality of quick connectors (QCP) 74 which include wire wrap pins 75 on one side and split cylinder connectors 76 on the opposite end. Accordingly chassis I2 provides that electrical cross connection of incoming or outgoing lines may be accomplished inside the chassis to contain emmission. As shown in Figure 4, the rear end of chassis I2 is fully enclosed, and includes a rear cover 77 which may be removed. Electrical and fiber optic cable entry and exit is preferably accomplished by cutting aperatures in the rear area and mounting the cable carrying conduit directly to the chassis, whereby the incoming and outgoing lines are fully shielded.

In Figure 5 there is shown an alternate, less secure embodiement of chassis I2 in which the top and end of the chassis, rear of the rear panel 20, is left open. Preferably, there is also provided in this embodiment a QCP field or other connection system, for instance a DV 25 connector. This embodiment may be used if desired where less data security is required.

As may be seen with respect to Figure 2, the present inventions allows for modules of different types. On the left side of Figure 2 there is shown five conversion modules I00 which in this instance are low speed four channel digital multiplexing modules which take a plurality of MIL I88, RS 232, RS 422 or RS 423 type signals and multiplex them onto a single fiber optic line. A further type of module II0, a test module, is also provided and has a double-wide front panel. Test module II0 may be connected to any one of modules I00 to accomplish certain basic test functions. In between modules I00 and II0 there are installed a plurality of front panel blanks I05, which serve to cover the unused front panel portion of the chassis and thus contain RF emission. Modules I20 are all power supply modules, which connect to the motherboard in the same manner as the other modules except that the motherboard includes female as opposed to male connectors for reasons of safety, although they have triplewide front panels. As shown, each module front panel or blank includes screws I03 which mate with the threaded tabs I07 on the chassis. Preferably, the front edge III of the

chassis I2 is formed so that when a panel is secured in place it is substantially flush with the edge, to give as tight a metal-to-metal seal as possible. Futhermore, as mentioned above, it is important that the front panels of the modules be formed with as straight of edges and with tight tolerances to provide a close, interference type fit between one another across the front of the chassis I2.

As mentioned above, the present invention utilizes a signal radiation suppression strategy in order to minimize total RF emission from the interface chassis. It has been found that this is necessary with respect to those circuit modules which normally carry data, specifically modules I00. Although test module II0 also carries data at certain times, the line or lines which are to be tested must normally be secured, i.e., sensitive data transmissions are halted before testing, so that there is no particular need to suppress radiation from this source. Likewise, power supply units do not carry data and thus do not require special design. Thus, the power supply units are not specifically illustrated, and any conventional low-noise supply capable of delivering the desired power will suffice. As will be described below, however, modules I00, and to some extent motherboard 60 are specially designed to suppress RF radiation therefrom or therethrough.

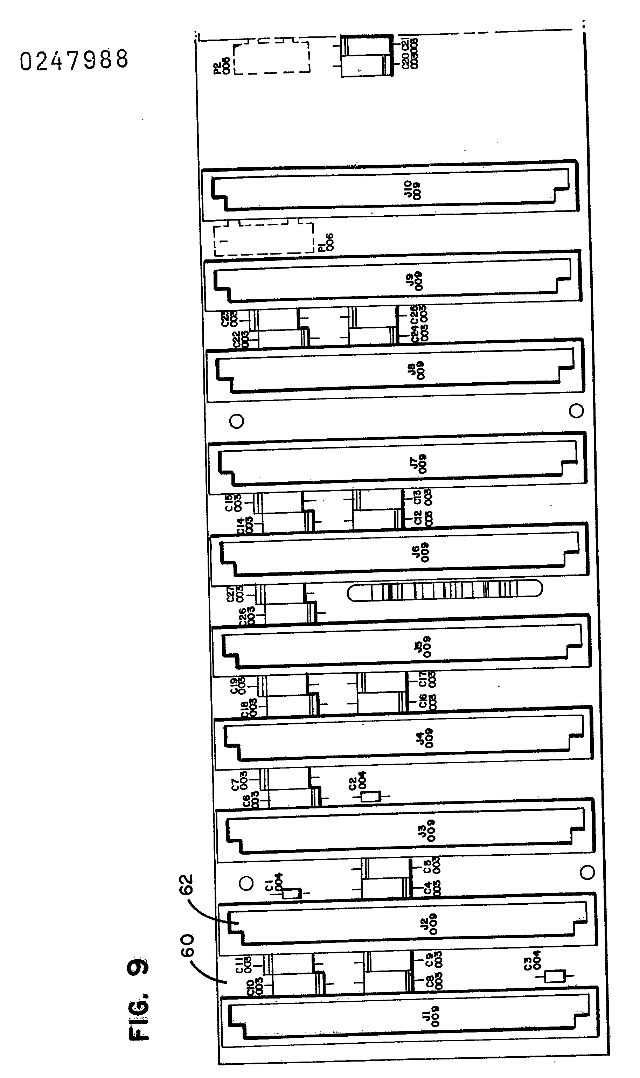

Referring to Figures 9 through I6, there is shown the PC layout and assembly of the motherboard 60. Figures 9 and I0 taken together show the connector and component layout of the board, with the right end of the portion shown in Figure 9 being partially repeated in Figure I0. As shown, the board includes a plurality of connectors 62, which are labelled JI-JI0, JI2, JI5 and JI8. Pin IA of each connector is oriented to appear in the upper left of the connector. In Figure II, one of connectors 62 is shown in more detail, having a component side 62a and a circuit side 62b. The printed circuit layouts of Figures I2 through I6 are reproductions of the Mylar sheets used in fabricating motherboard 60. As may be appreciated by those skilled in the art, the artwork may be registered with the component layout of Figures 9 and I0 in order to determine the exact details of fabrication and assembly of the board.

The electrical schematic for the motherboard 60 is set forth fully in the drawings of Figures I7 through 28, which show the preferred connections to the power supply boards and other relevant connections. It should be noted that in Figures I7 through 28, the three-pronged ground symbol represents chassis ground, which is preferably connected to signal ground using a factory-installed shorting plug which is located in close proximity of the power supplies. As used in the present invention, the chassis ground must be a non DC-current conducting shield. In other words, the chassis ground is not used to return any DC or digital signals. Rather, it is used only to return current from absorbed RF emission.

Although the motherboard 60 design is set forth fully in all respects, it is most relevant to the present invention with regard to the separate ground lines provided for the different power supply voltages, and for the use of chassis ground plane on the component and solder side of the board which absorbs RF emission. With respect to the supply lines, it has been found that separating the grounds for all different supplies substantially retards the crosstalk and the antenna effect that is otherwise present when signal noise is spread over the circuitry on common ground busses.

The rear connectors JI-JI0 are provided to mate with either data conversion modules or with test modules, and thus have rear tails. The power supply connectors, however, JI2, JI5 and JI8, are preferably female on the rear side since no external connections are required.

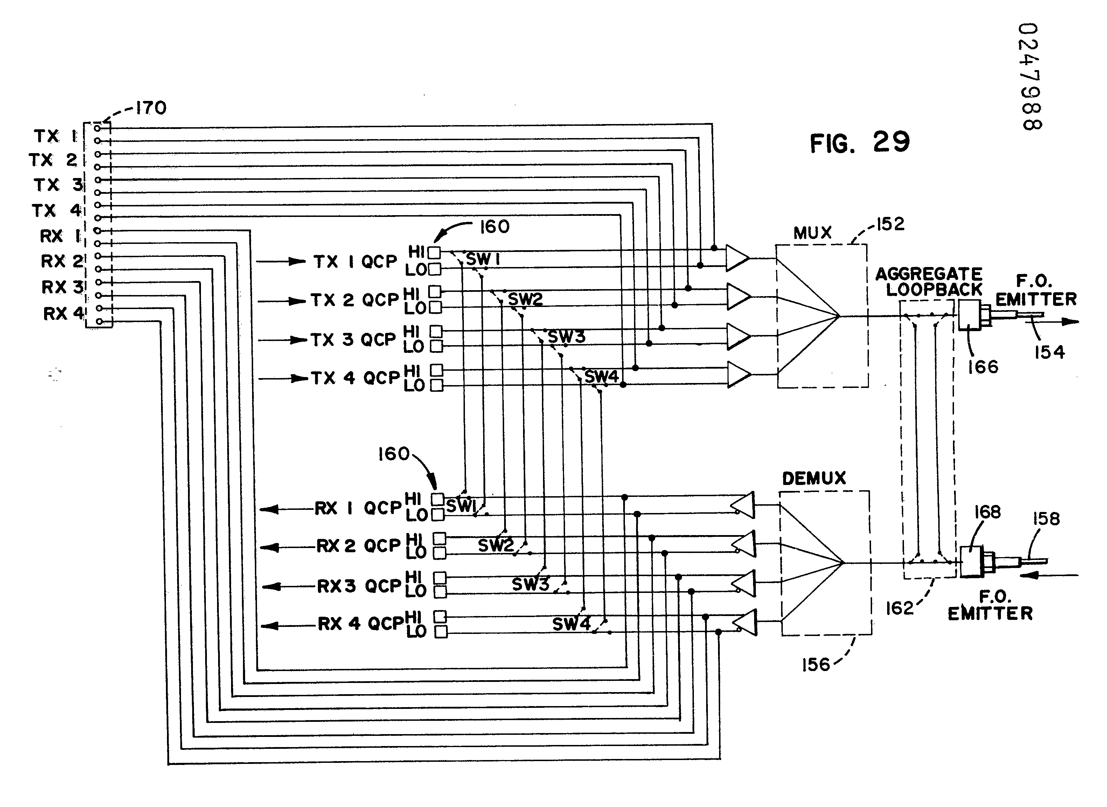

One of the low speed multiplexer circuit modules I00 for converting electrical channels to optic channels, will now be described in detail. Referring first to Figure 29 there is shown a schematic electrical diagram of the basic circuitry of the multiplexer module I00. Circuitry I50 includes a multiplexer I52 for multiplexing and encoding a plurality of transmit (TX) channels onto a single fiber optic fiber I54. Similarly, a demultiplexer I56 is provided to decode and demultiplex a plurality of receive (RX) data channels carried on fiber I58. Preferably, a quick connect panel including a plurality of quick connect connectors (QCP) I60 are provided at the rear of the chassis I2, as was mentioned above. One pair of these connectors is thus used to terminate one transmit or receive pair for a RS 232 type data channel. These connectors are connected through the corresponding motherboard connector 62 to the corresponding one of either multiplexer I52 or demultiplexer I54, as illustrated.

Circuitry I50 further includes five loop back options, one individual loopback for each transmit and receive pair, shown as SWI-SW4 and one aggregate loop back option I62, which provides that both the fiber optic converters I66 and I68 are looped together as well as multiplexer I52 and demultiplexer I54. As is illustrated with respect to Figure 2, and as will be later illustrated, the five loop back switches are all accessible from the front panel of the module I00. In addition to front panel access to the loop back switches, the module I00 further provides a front panel accessible connector port I70, which as illustrated provides access to each transmit and receive pair handled by the module.

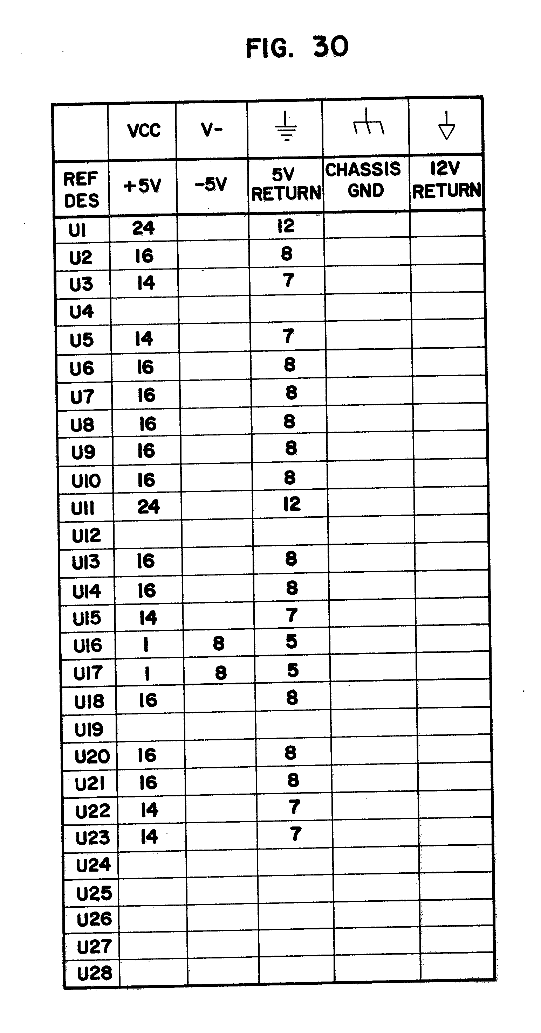

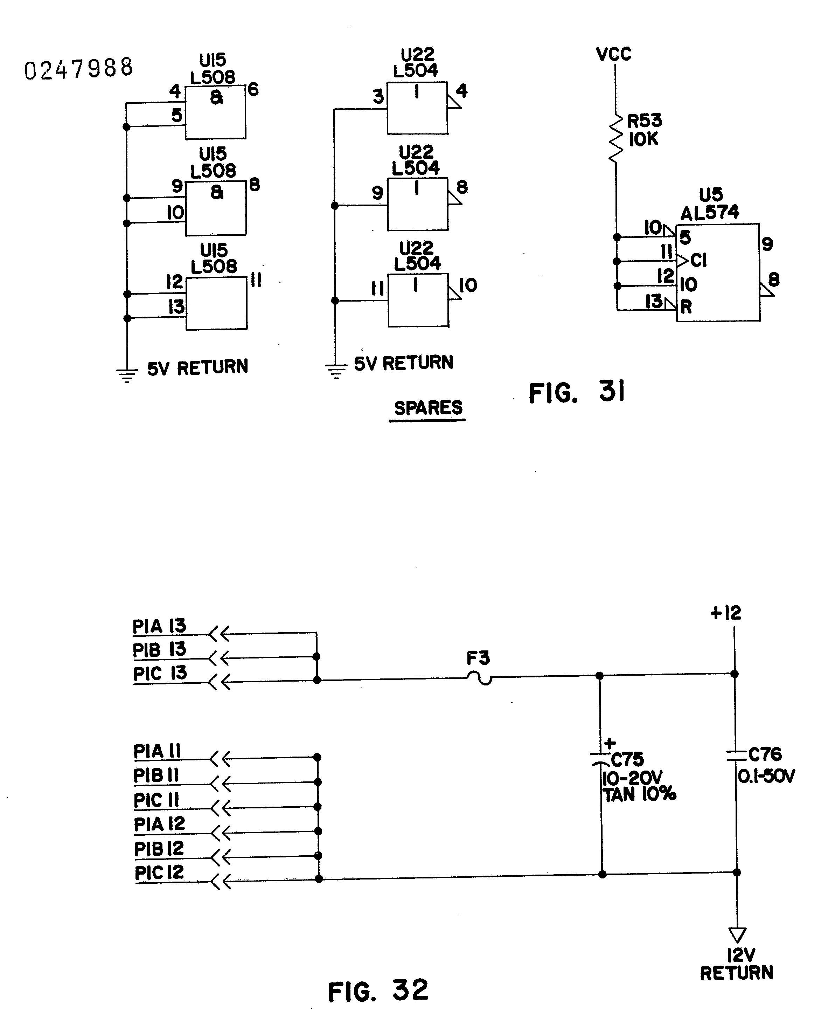

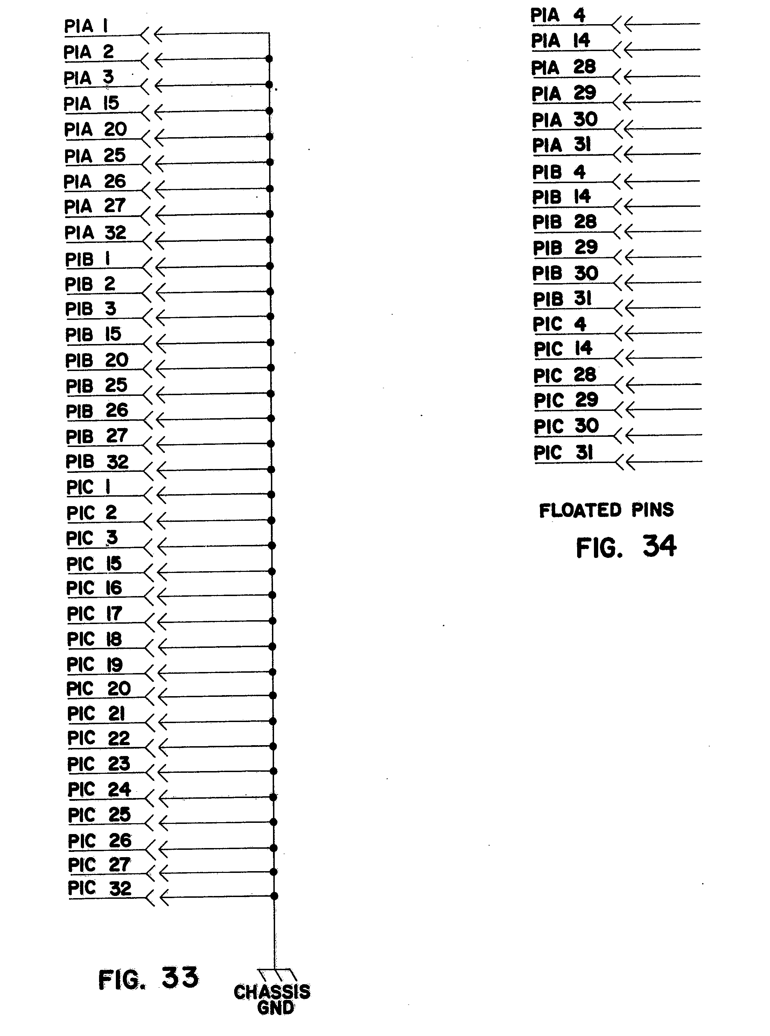

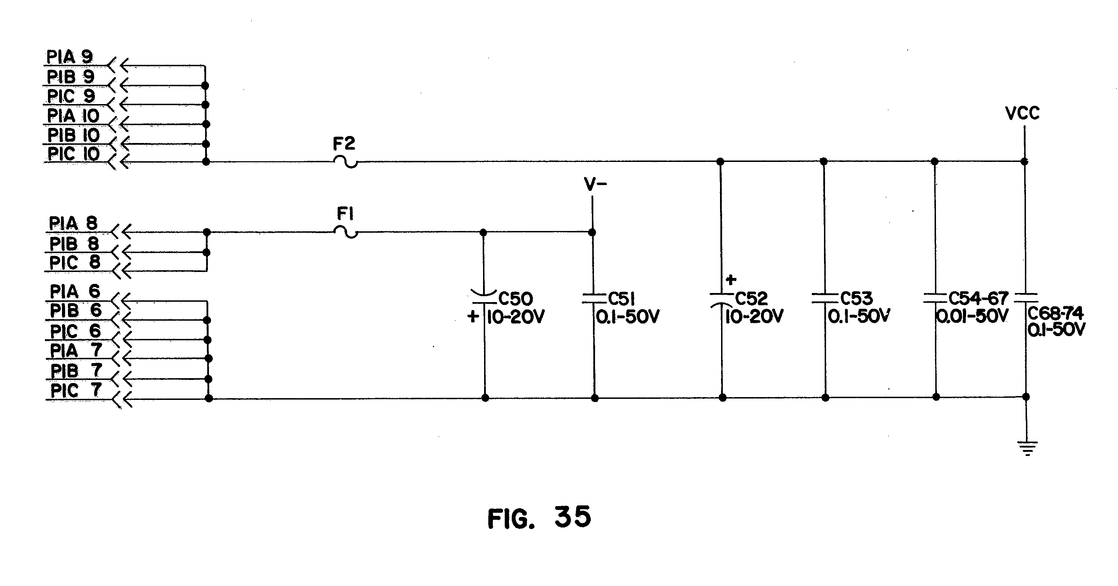

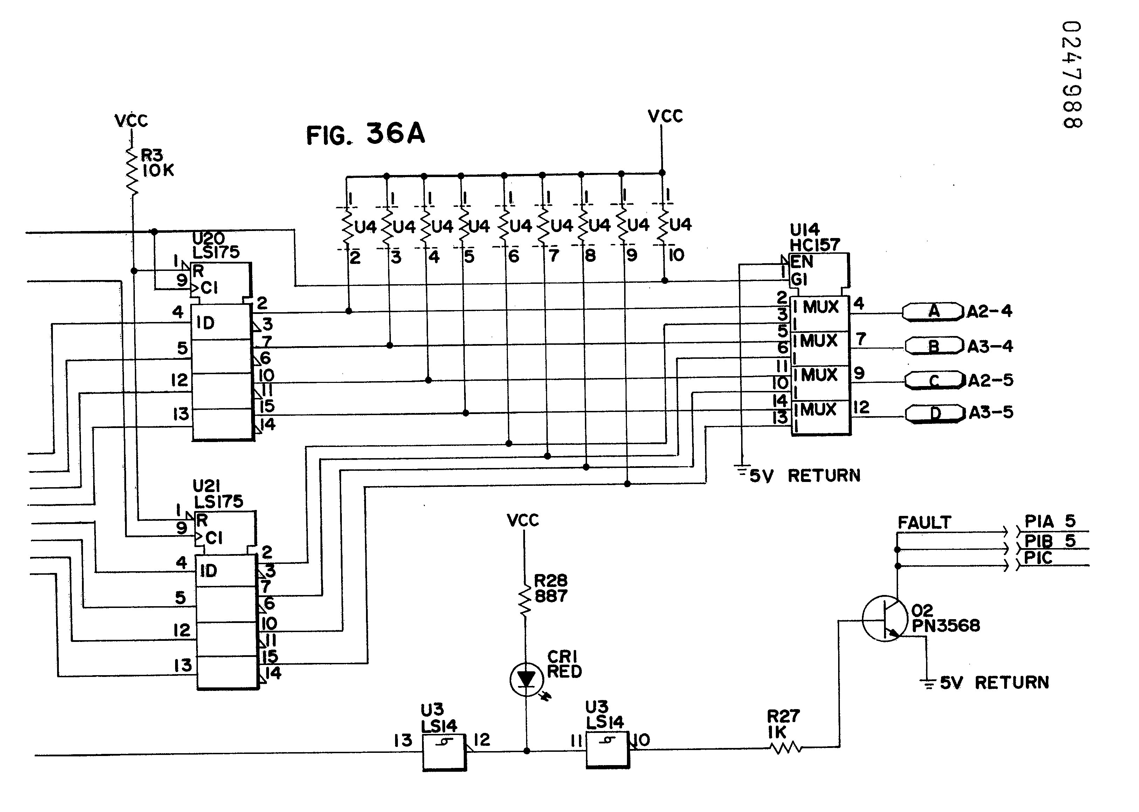

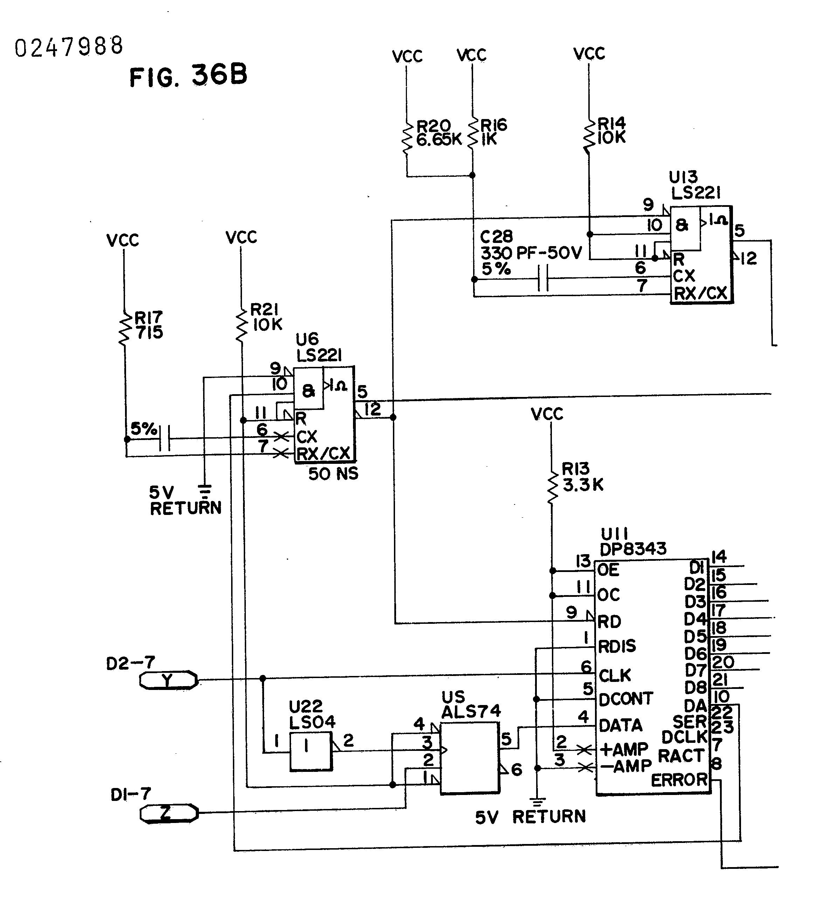

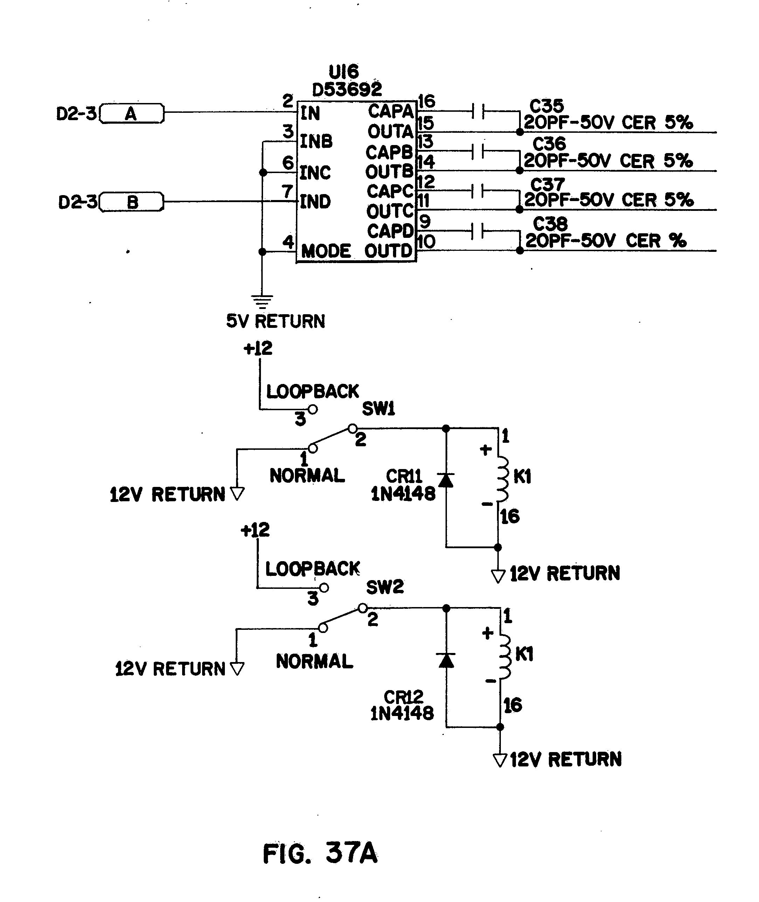

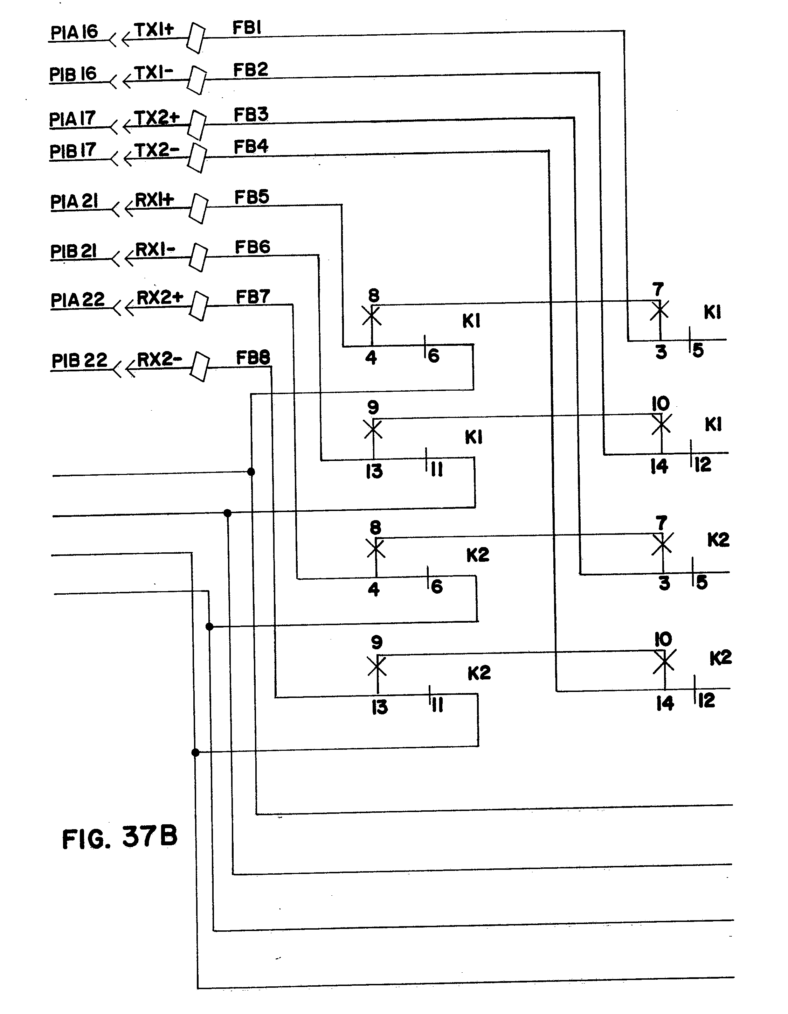

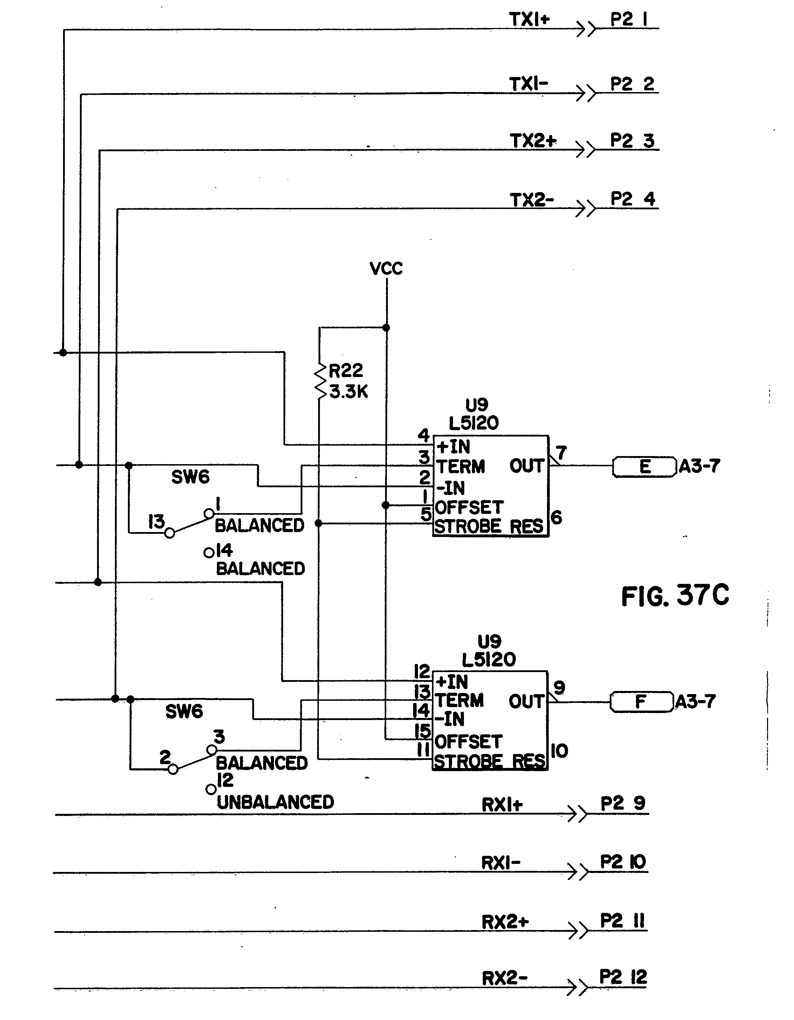

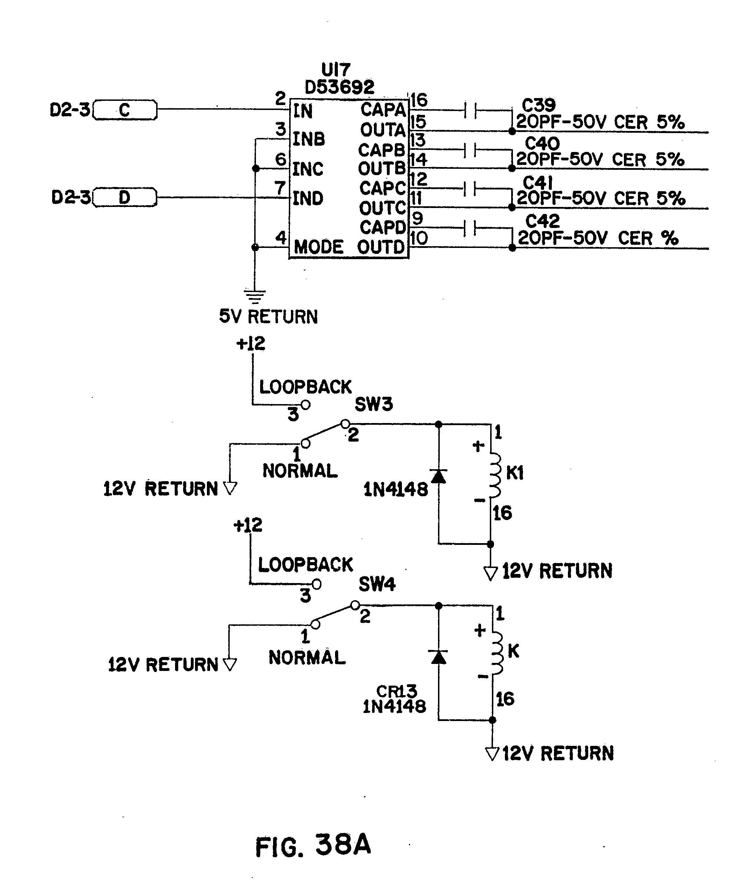

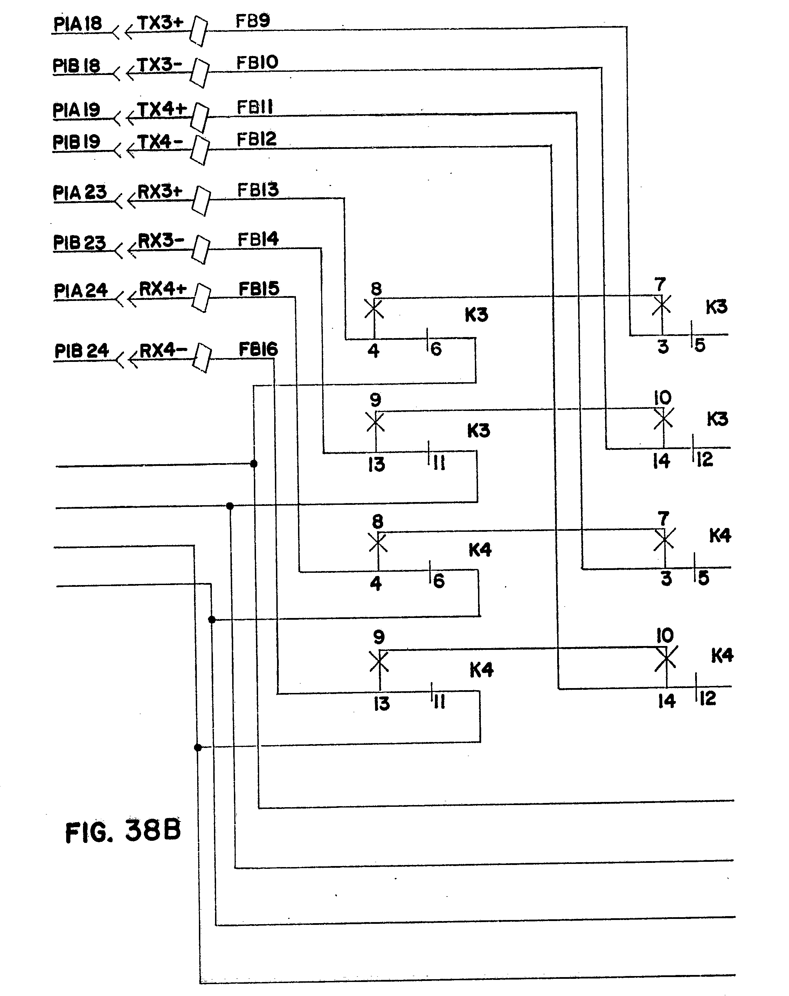

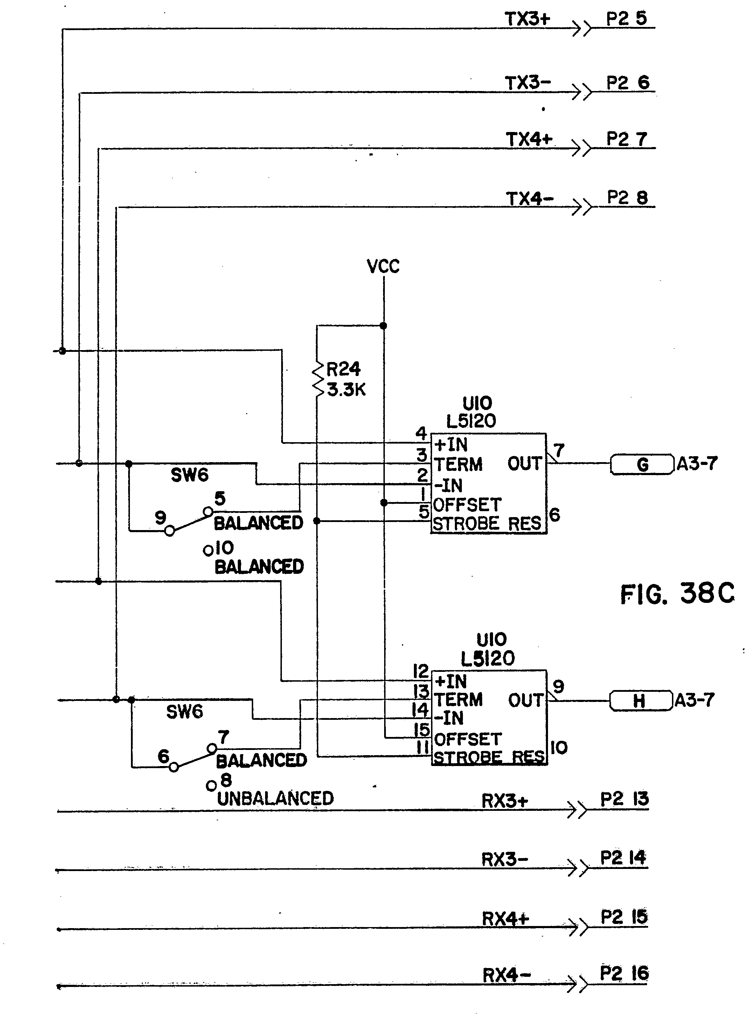

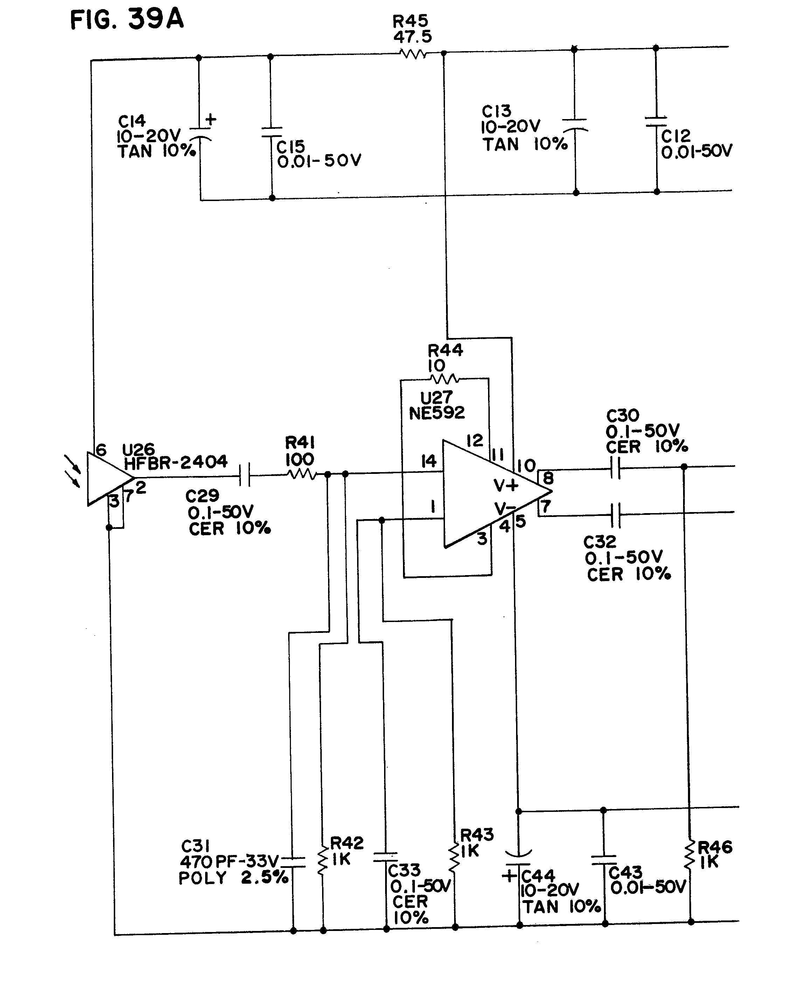

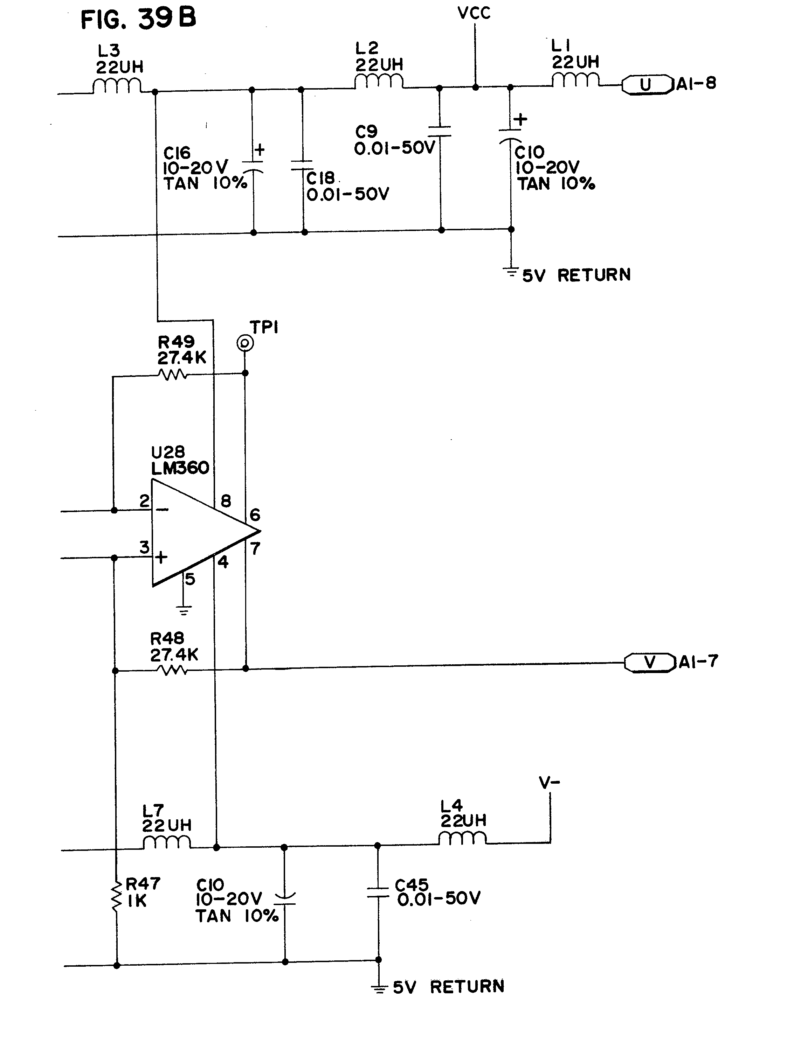

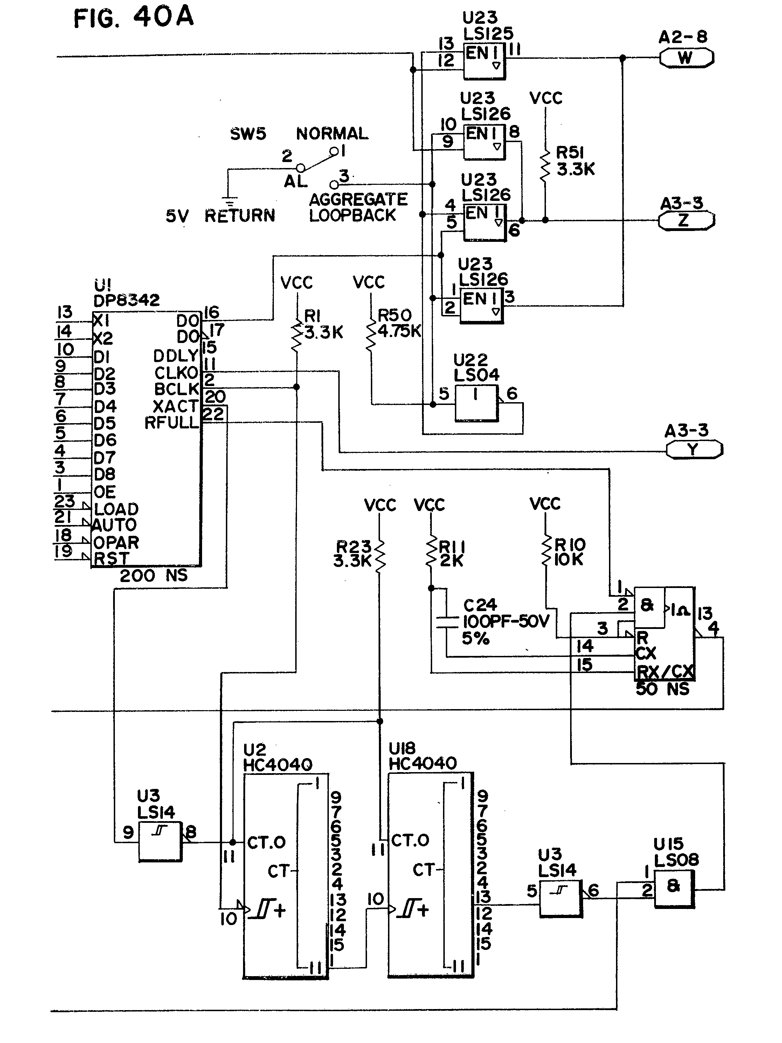

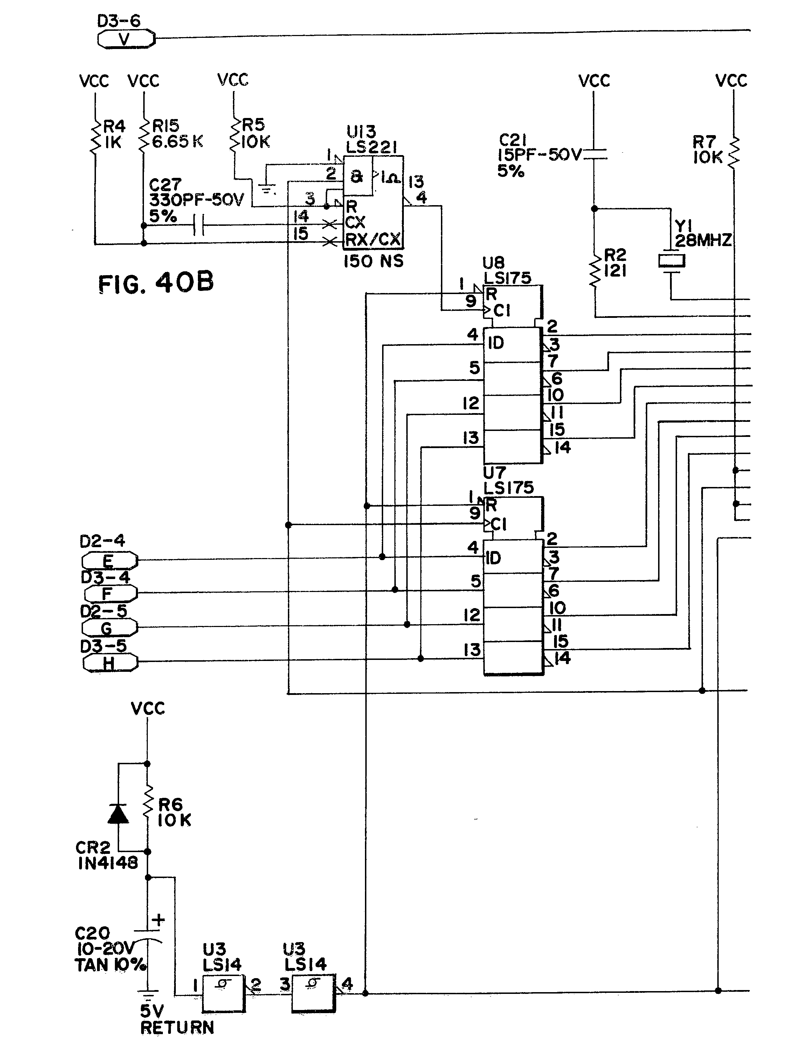

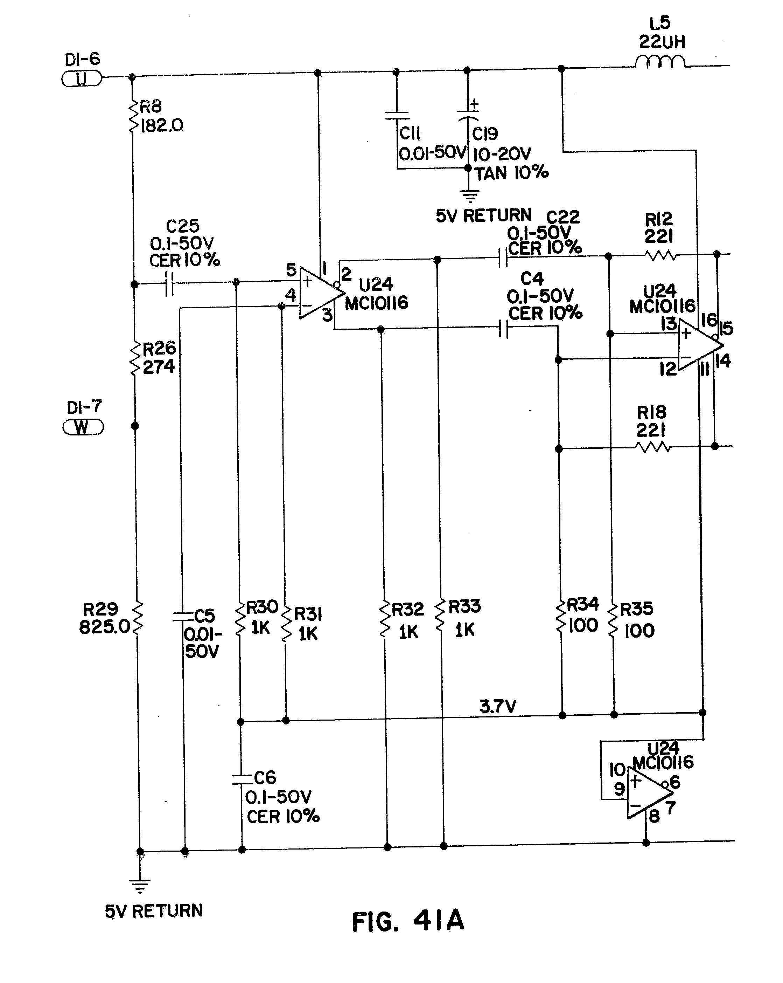

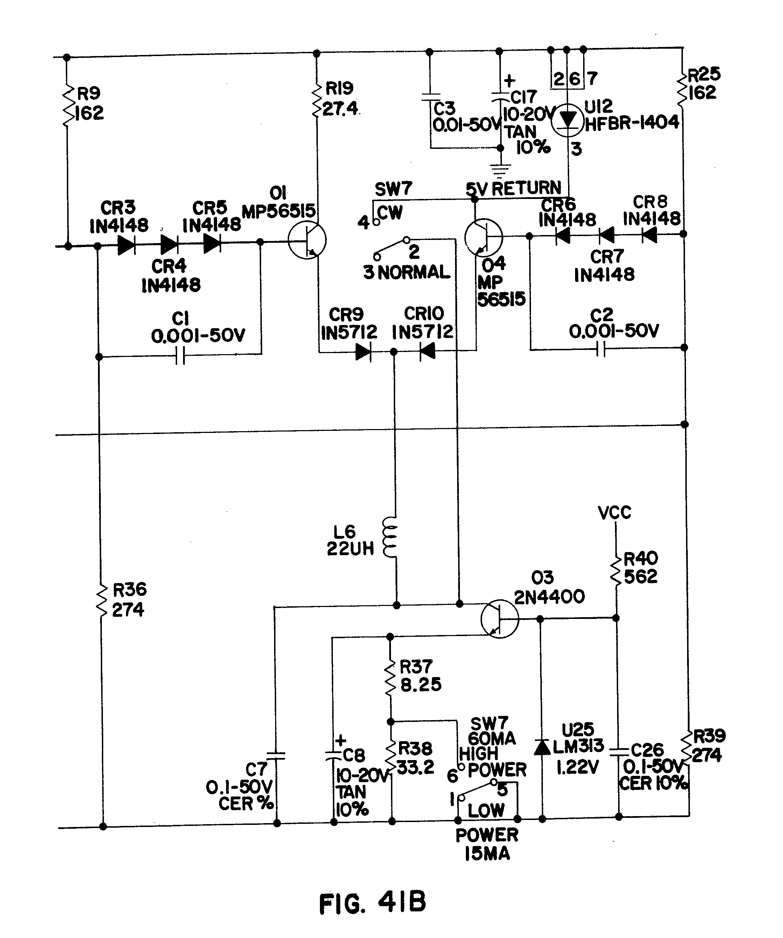

Referring now to Figures 30 through 4I there is illustrated in detail the electrical schematic for one of modules I00. Because the schematics are self-explanatory upon inspection they will only be briefly described herein. First, those figures which are broken down with alpha designations, for instance 36A and 36B, include interconnections from the schematic of one drawing to the next. These interconnections are not labeled but may be readily correlated by aligning the sheets side-by-side. Furthermore, references throughout the figures to "U" designations relate to integrated circuit elements, while "C" refers to capacitors, "R" to resistors and "L" to inductors. Connectors are designated with the prefix "P", with "PI" referencing the in-line connector on the rear of module I00 and

"P2" referring to the front panel port connector l70. finally, the alpha labeled connector tags A through Z designate interconnection points as between figures of different numbers, for instance between 36A and 39B.

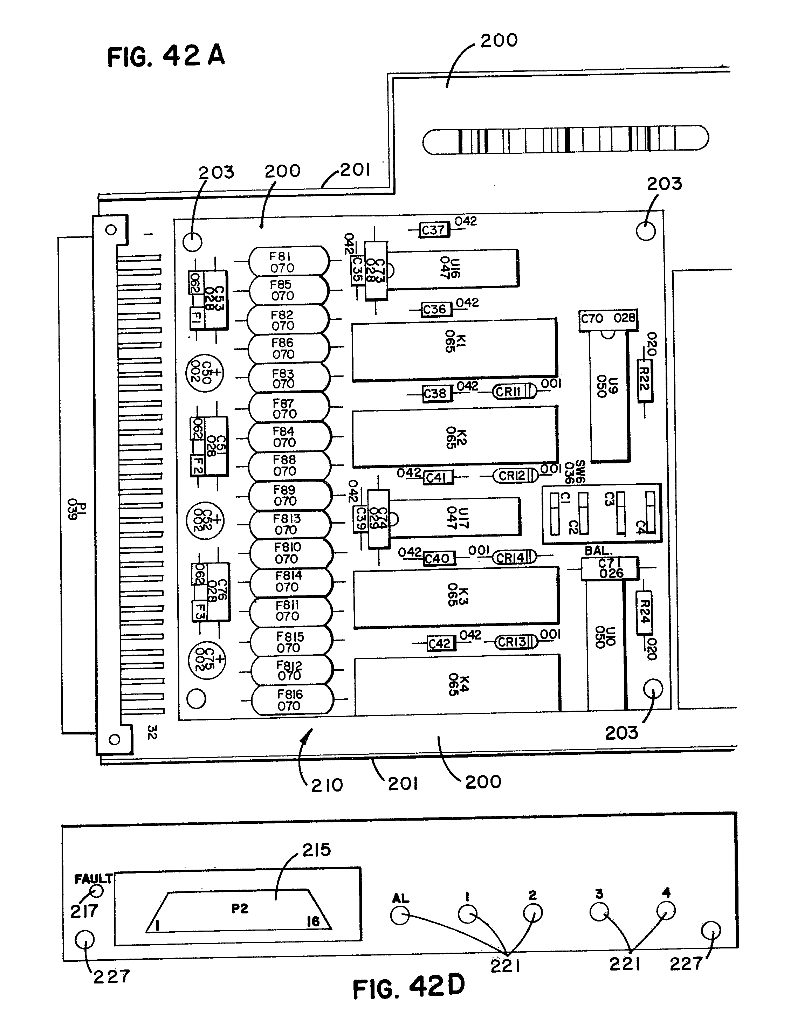

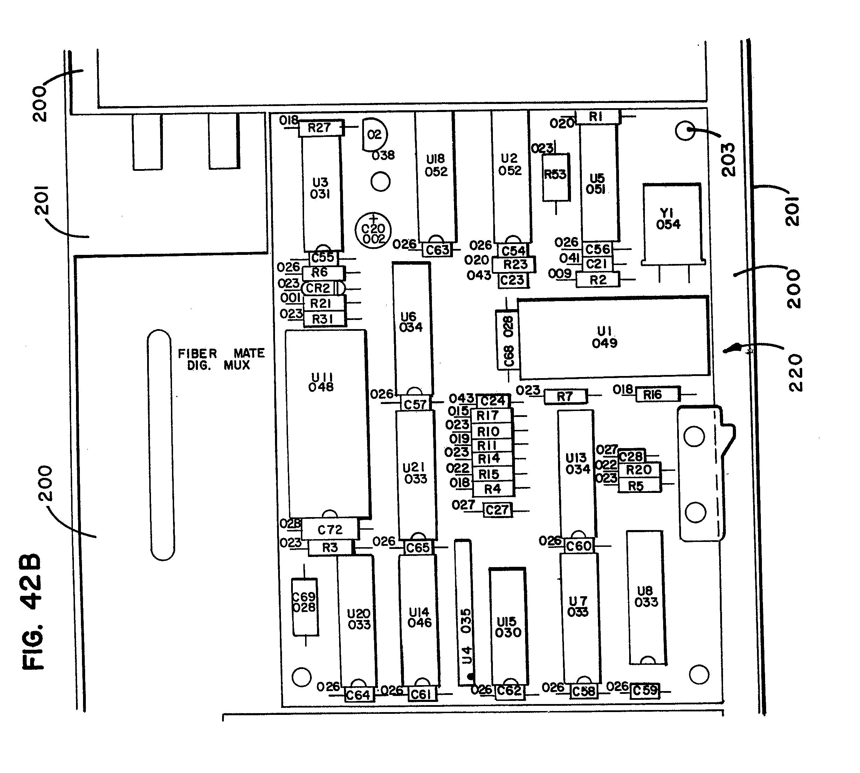

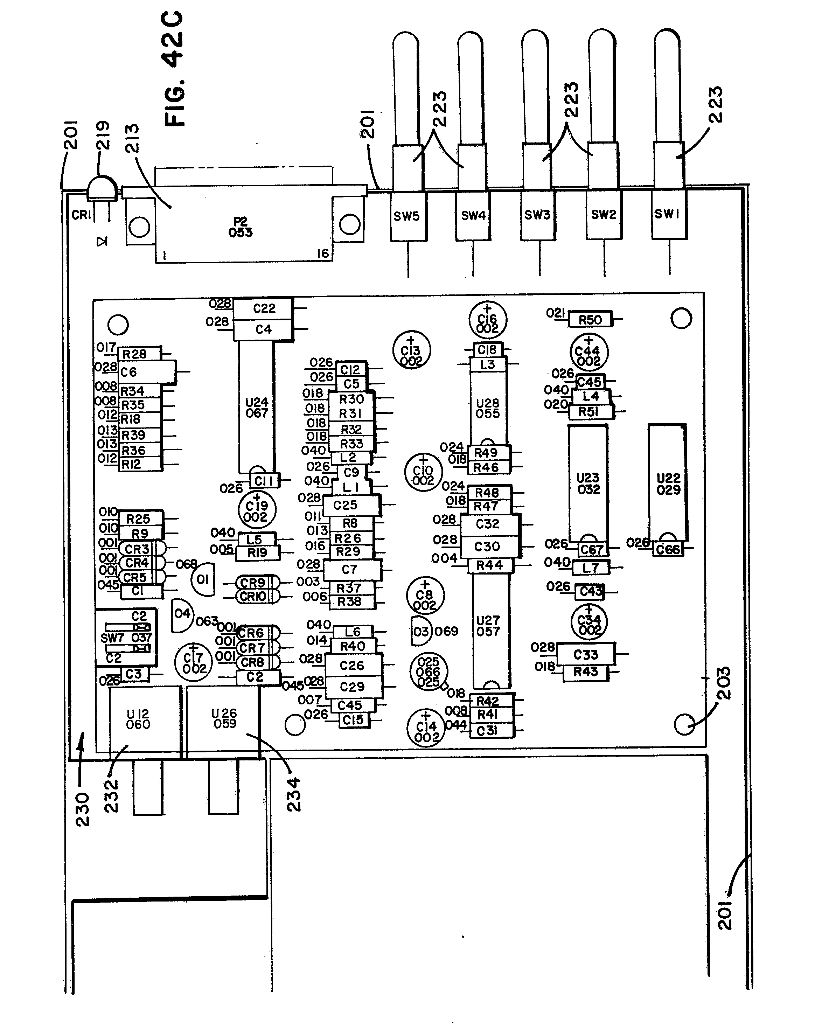

Referring now to Figures 42A, 42B, 42C and 42D (the front panel) which when laid side-by-side show the assembly and component layout on a module l00, the general nature of the corresponding circuits of Figures 30 through 4l will be given. The circuits of module l00 are physically and electrically divided into three areas. A first area 2l0 is located toward the rear of the circuit board 200, as shown in Figure 42A, and pro vides for interfacing with the electrical channels, including the functions of converting between five volt logic and the higher voltage RS 232 type logic levels. The RS 232 interface section is adjacent the multiplexing/demultiplexing circuit area 220, which is located in the middle of the board, as shown in Figure 42B. This area of the circuit functions to multiplex and demuliplex the RS 232 channels, and consequently exhibiting relatively high frequency operation, which is most problematic in terms of RF radiation. A final area of the board is shown in Figure 42C, namely the fiber optic driver/receiver and loop back circuit section 230. Accordingly, section 230 is located adjacent the loop back switches SWl-SW5. As illustrated, the fiber optic coupling units 232 and 234 are located sufficiently forward in the card to allow that a technician inserting or extracting a module may connect and disconnect fibers to the units 232 and 234 while the module is supported in the chassis slots.

Accordingly, by correlating the position of the components on the board 200 as described above with the corresponding components shown in the detailed electrical schematics, the nature and function of the various circuit schematic elements should become apparent.

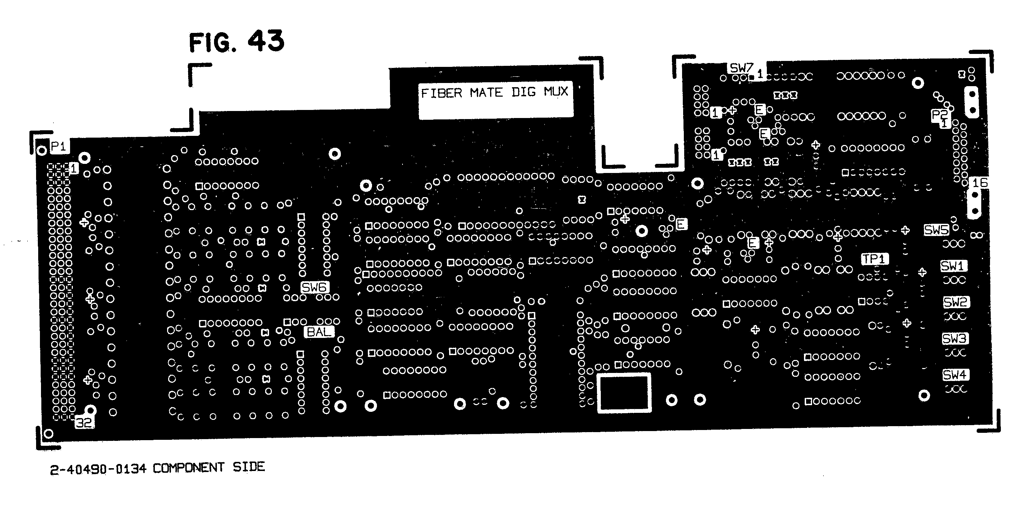

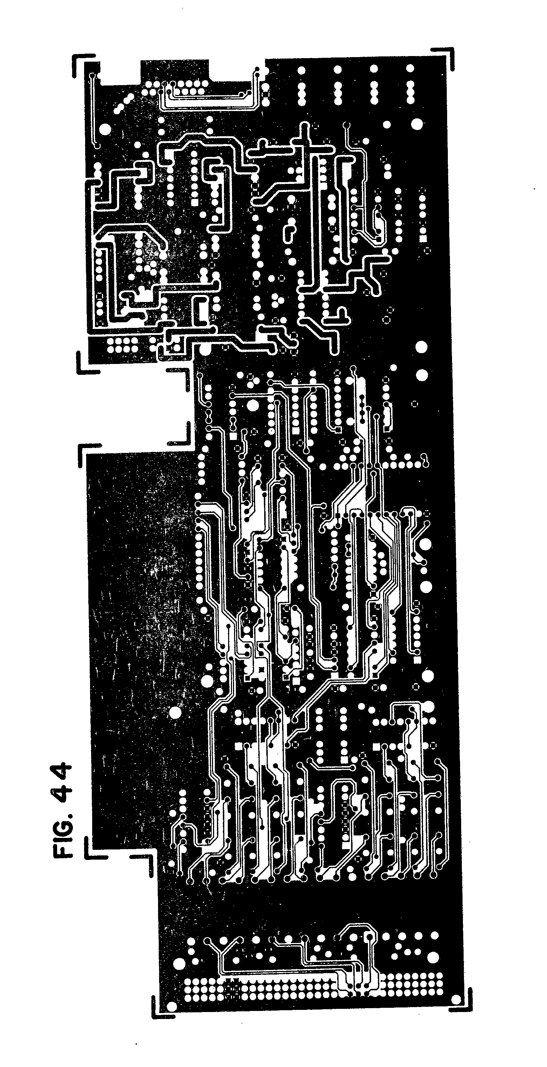

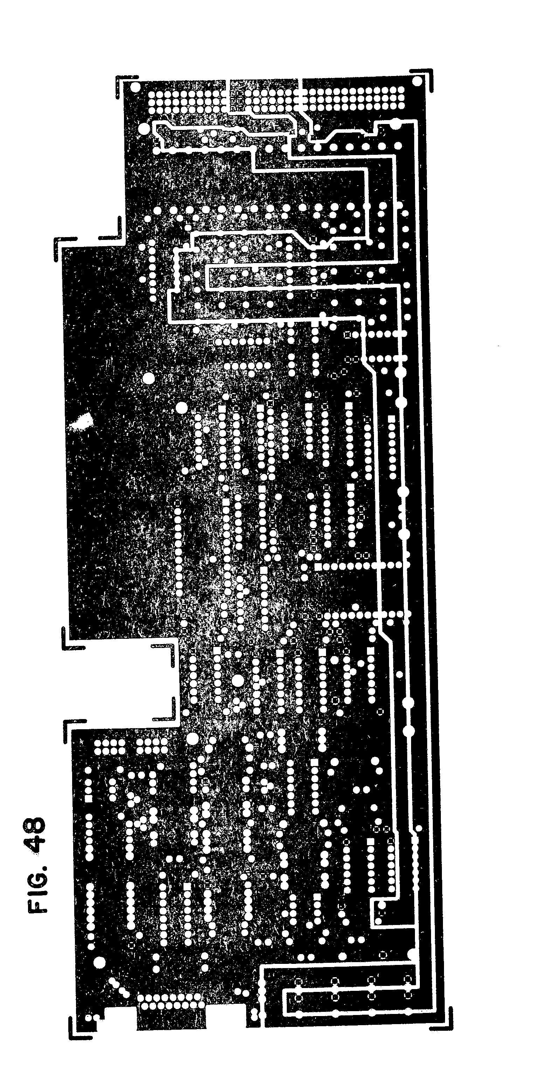

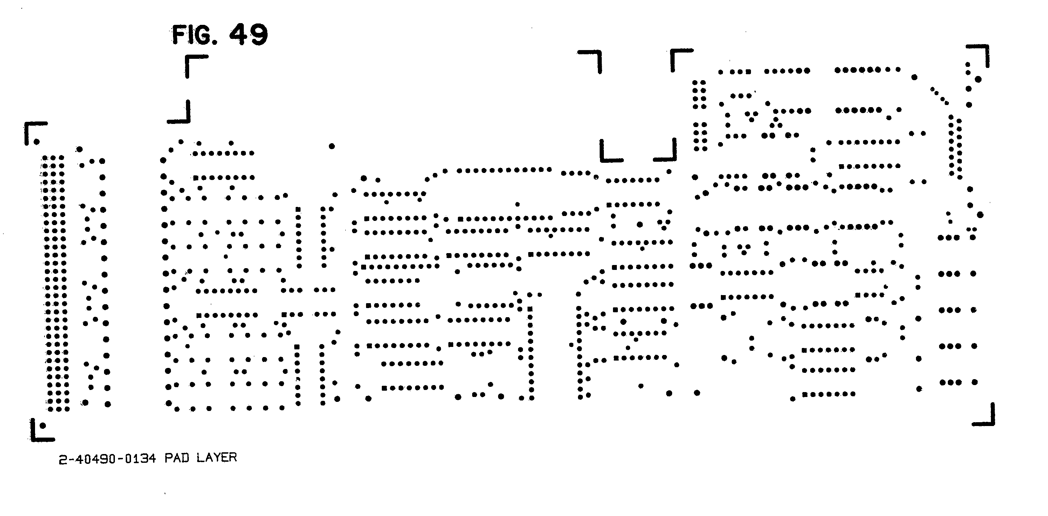

Referring now to Figures 43 through 49 the circuit board artwork and printed circuit layout will be described. Circuit board 200 is a six layer printed circuit board which is specially designed to suppress RF radiation from the module. Each layer of the board is represented by one of Figures 43 through 48, with Figure 49 representing the pad artwork for the layer of Figure 43. Figure 43 represents the first layer of the board on the component side. As shown, this layer is substantially covered with a ground plane which is con nected to the chassis ground, a non-current conducting ground. Figure 44 represents the second layer of the board 200 and provides for interconnection of components. This second "signal" layer also includes a substantial plating of ground plane, in this case the signal ground for the five volt supply.

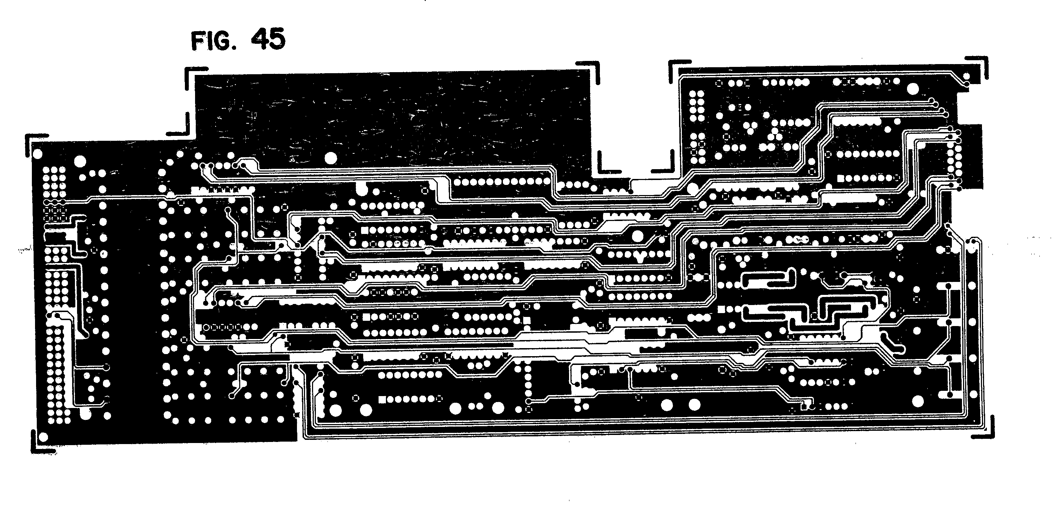

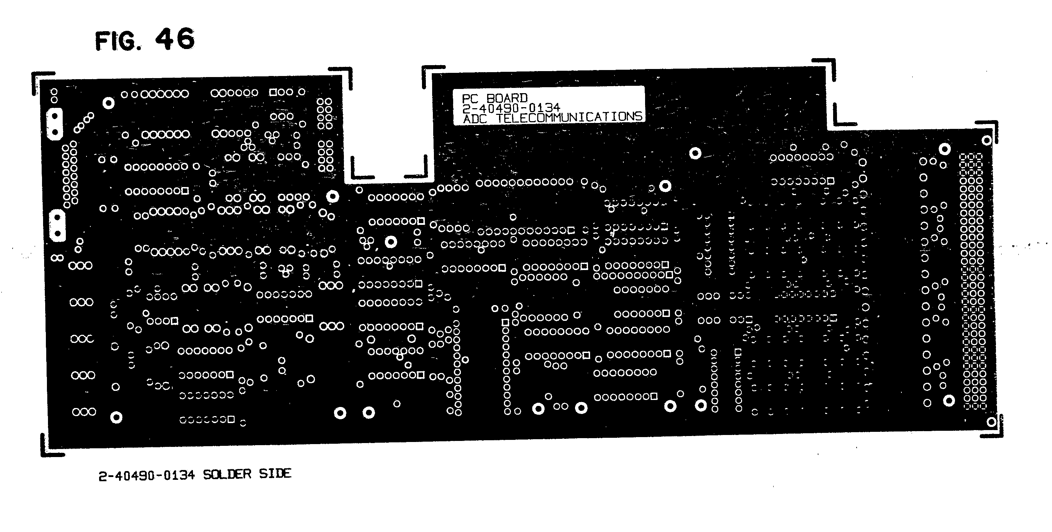

The third layer, shown in Figure 45 is dedicated to connecting the front panel port connector to the RS 232 channels entering the board at the rear thereof. Accordingly, this layer is known as the "interconnect layer". The present invention buries this layer internally to the board in order to minimize the antenna effect inherent in long printed circuit runs. Furthermore, the interconnect layer is also liberally plated with signal ground plane. The fourth layer of the board is shown in Figure 46 and consists of power distribution runs and is also liberally plated with signal ground.

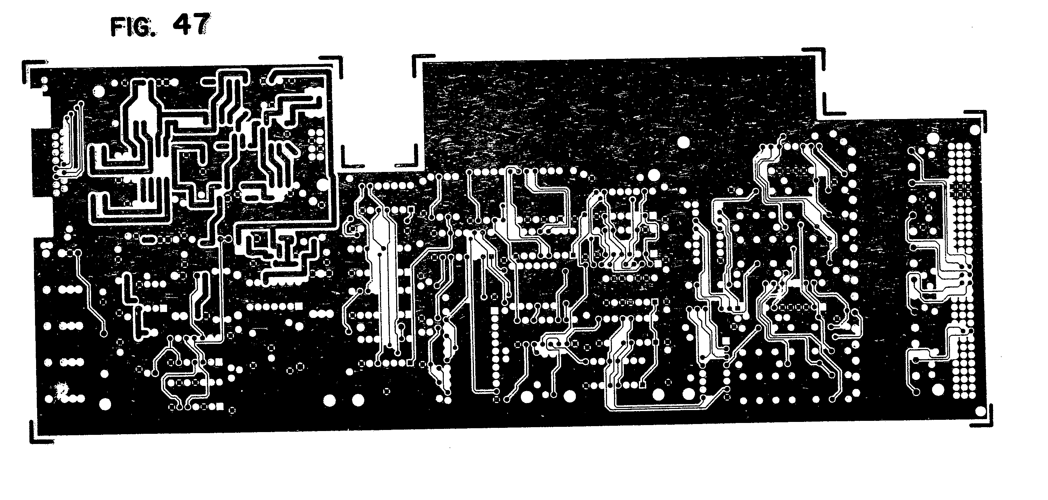

A further "signal" layer, consisting of the fifth layer in the board is shown in Figure 47. This layer, like layer number two also includes a substantial signal ground plane area. It is important to note, although not readily apparent from the drawing, that the circuit board layout of the present invention separates as much as possible, as between the two signal routing layers, the runs corresponding to the transmit and receive circuits. This is believed to be beneficial in decoupling the transmit circuits, which are a dominant source of RF radiation, from the receive circuits whereby leakage of RF radiation from the transmit circuit through the receive circuits and out can be minimized. Furthermore, it has been found that the particular constant current fiber optic converter driver circuit of the present invention has also been quite useful in reducing excess RF radiation. The final layer of the board constituting the solder side of the board is similar in design to the first layer including a substantial chassis ground plane.

As indicated earlier, each of modules l00 includes a sheet metal support 20l to which the printed circuit board is mounted with standoffs 203. Standoffs 203 are connected to chassis ground on the printed circuit board whereby the support provides a further ground plane for wicking up stray RF.

Accordingly, the board design of the present invention provides for suppressing RF radiation internally to the interface chassis whereby a front panel containment cover is made unnecessary. It is believed that the multilayer ground-plane sandwiching of signal and interconnect layers is key to suppressing RF to the extent necessary to allow an uncovered front panel. Moreover, the present invention not only provides for an uncovered front panel, but also for an uncovered front panel port.

Figure 42D shows the front panel 2ll of module l00. Preferably connector 2l3 (P2) (Fig. 42C) is a shielded data link (SDL) connector which fits through aperture 2l5 in panel 2ll. Apertures 22l are provided for toggle switches 223, which are preferably tightly mounted to panel 2ll with metal bushings. LED aperture 2l7, for fault indicator LED 2l9, is preferably made as small as possible to aid RF leakage therethrough. Screw-holes 227 are provided for the mounting screws.

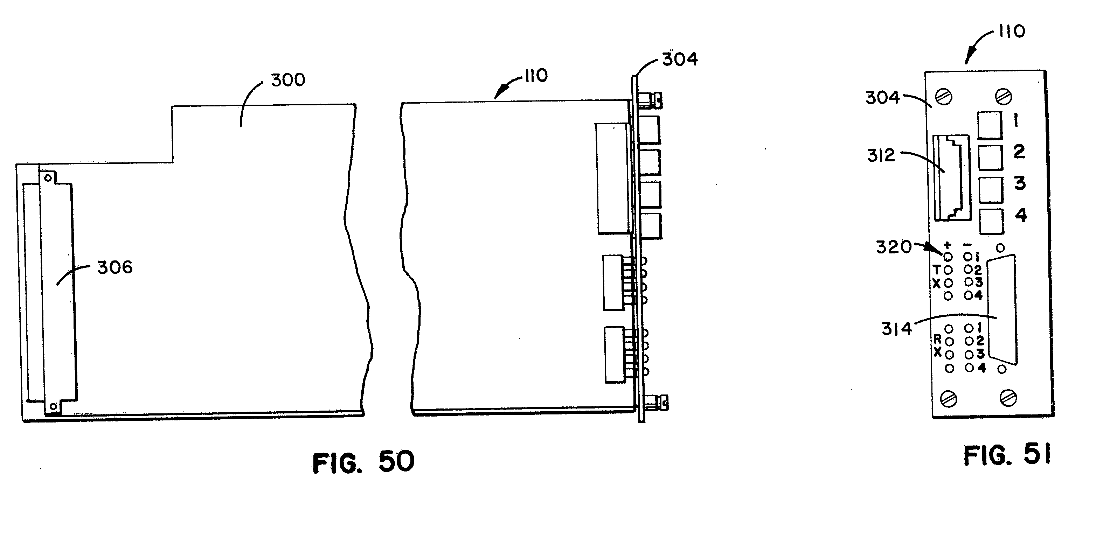

Referring now to Figures 50-52 the test module ll0 according to the present invention will be described. The general mechanical features of module ll0 are shown in Figures 50 and 5l. Module ll0 includes a circuit board 300, which may be of conventional design as noted hereinabove, to which is connected a front panel portion 304, preferrably constructed of ferrous metal for shielding, and a rear connector 306, as required to mate with the motherboard connectors. Mounted on front panel 304 are four loop back switches 3l0, a monitor port, or jack, 3l2 and a further twenty five position D-subminiature connector 3l4. Also mounted on front panel 304 are a plurality of LED indicators 320, enough for monitoring four transmit and four receive channels, both sides.

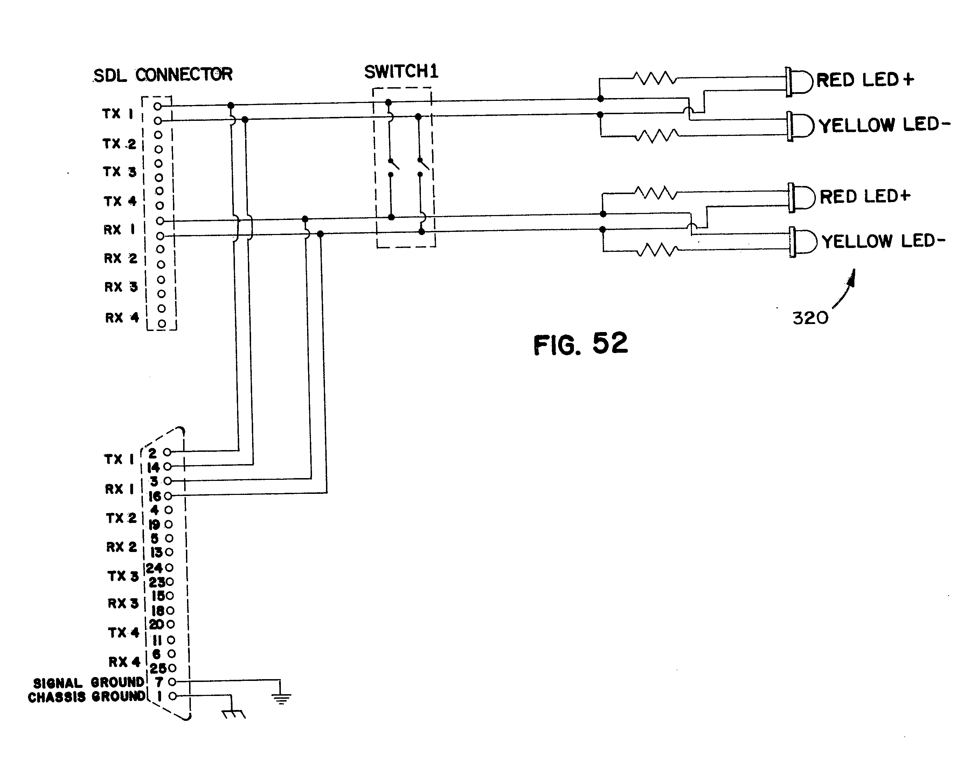

The circuit schematic for module llO is shown in Figure 52. As shown, the basic elements of the circuit are the LEDs 320, the loop back switches 3l0 (not all are shown), and the two connectors 3l2 and 3l4 to which signals may be ported from another module, for instance the multiplexer module 50.

Thus, as described above, the present invention provides an electrical to fiber optic conversion unit characterized by low RF emissions while providing for the much desired unrestricted front panel access. Accordingly, the present invention overcomes the drawbacks of conventional prior art conversion units wherein security must be compromised in order to access the front panel of the conversion circuitry. Furthermore, the present invention provides that data security is not dependent upon the proper replacement of a front RF containment cover.

It is contemplated that modules for high speed data conversion, voice frequency multiplexing and telephone interfacing, together with corresponding test features may also be provided as one of modules 50, using the same circuit board approach taken with respect to the low-speed channel multiplexer modules l00. Furthermore, it is contemplated that a separate power supply chassis may be desirable in certain instances, with a separate chassis for conversion modules, whereby higher densities may be achieved.

Although the invention has been described herein in its preferred form, those skilled in the art will recognize that various modifications and changes may be made thereto without departing from the spirit and scope of the claims appended hereto.

**Claims**

l. A low RF emission electrical to fiber optic conversion unit comprising:

a chassis constructed of ferrous metal, said chassis including four side walls and a rear wall and having an open front end;

said chassis further including a plurality of card guides mounted to a pair of opposing walls internally thereof;

said rear panel having mounted thereto a motherboard printed circuit board including a plurality of connectors for receiving a cooperating mating connector;

one or more conversion card modules for converting electrical signals to fiber optic signals, said modules including a first sheet metal support and a printed circuit card mounted thereto with a plurality of metal standoffs, said support sized to slide into said card guides on the top and bottom edges thereof, said support having affixed to one end thereof a front panel generally perpendicular thereto;

said printed circuit board having a plurality of printed circuit layers, the top and bottom layers thereof substantially covered with chassis ground plane, wherein the chassis ground plane is a non DC or digital signal current conducting ground, said printed circuit board having mounted thereto a plurality of electrical components for carrying out said conversion, said components interconnected on printed circuit layers sandwiched between said top and bottom layers; and

panel means for covering the remaining open end of said chassis while leaving said front panel or panels uncovered.

0247988

FIG. 1
120
DC POWER SUPPLY
22
10
16
111
111
107
30
12
64
14
100
14
60
62
20
16
69
FIG. 7
30
30
7
7
FIG. 6

50
103
100
105
110
120
FAULT
AL
1
2
3
4
T
X
R
X
DC
POWER
SUPPLY
ADC
+5V
-5V
+12V
-12V
P/S 1
P/S 2
ON
OFF
103


FIG. 2

0247988

60
111
107
63
30
14
62
19
18
17
16
15
13
12
11
10
9
8
7
6
5
4
3
2
1


FIG. 3

0247988

77
70
72
17
20
60
62
12
69
16
FIG. 4

0247988

72
74
76
75
17
20
60
62
12'


FIG. 8

FIG. 5

FIG. 9

P2 006
C20 C21 003 003
J10 009
P1 006
J9 009
C23 003
C22 003
C25 003
C24 003
J8 009
J7 009
C15 003
C14 003
C13 003
C12 003
J6 009
C27 003
C26 003
J5 009
C19 003
C18 003
C17 003
C16 003
J4 009
C7 003
C6 003
C2 004
J3 009
C5 003
C4 003
C1 004
62
J2 009
60
C11 003
C10 003
C9 003
C8 003
C3 004
J1 009

0247988

FIG. 11
62
62a
62b

FIG. 10
60
62
J18
012
J15
012
J12
012
C39 003
C38 003
C37 003
C36 003
C43 003
C42 003
C41 003
C40 003
C35 003
C34 003
C31 003
C30 003
C29 003
C28 003
P3
007
C33 003
C32 003

2-42932-4633 COMPONENT SIDE

FIG. 12

ADC TELECOMMUNICATIONS
2-42932-4633 SOLDER SIDE
FIBER MATE
MOTHERBOARD
PC BOARD 2-42932-4633

FIG. 13

0247988

2-42932-4633 COMPONENT SIDE SOLDERMASK

FIG. 14

2-42932-4633 SOLDER SIDE SOLDERMASK

FIG. 15

1247988

FIG. 16

2-42932-4633 PAD LAYER

0247988

12V RETURN
C4
10-20V TAN
+12V
C5
10-20V TAN
-12V
J3A 11
J3B 11
J3C 11
J3A 12
J3B 12
J3C 12
12V RETURN
J2A 11
J2B 11
J2C 11
J2A 12
J2B 12
J2C 12
5V RETURN
C6
10-20V TAN
+5V
C7
10-20V TAN
-5V
J3A 6
J3B 6
J3C 6
J3A 7
J3B 7
J3C 7
5V RETURN
J2A 6
J2B 6
J2C 6
J2A 7
J2B 7
J2C 7
FLT BUS
J3A 5
J3B 5
J3C 5
+5V
J3A 9
J3B 9
J3C 9
J3A 10
J3B 10
J3C 10
FLT BUS
J2A 5
J2B 5
J2C 5
-5V
J3A 8
J3B 8
J3C 8
-5V
J2A 8
J2B 8
J2C 8
+12V
J3A 13
J3B 13
J3C 13
-48V RETURN
J3A29
J3B29
J3C29
+12V
J2A 13
J2B 13
J2C 13
ALARM
J3A 4
J3B 4
J3C 4
-12V
J3A 14
J3B 14
J3C 14
ALARM
J2A 4
J2B 4
J2C 4
-RING
J3A30
J3B30
J3C30
-48V
J3A28
J3B28
J3C28
J3A 1
J3B 1
J3C 1
J3A32
J3B32
J3C32
-RING
J2A30
J2B30
J2C30
+RING
J3A31
J3B31
J3C31
+RING
J2A31
J2B31
J2C31


FIG. 17

0247988

FIG. 18

12V RETURN
C8 10-20V TAN
+12V
C9 10-20V TAN
-12V
J1A 11
J1B 11
J1C 11
J1A 12
J1B 12
J1C 12

5V RETURN
C10 10-20V TAN
+5V
C11 10-20V TAN
-5V
J1A 6
J1B 6
J1C 6
J1A 7
J1B 7
J1C 7

FLT BUS
J1A 5
J1B 5
J1C 5

+5V
J2A 9
J2B 9
J2C 9
J2A 10
J2B 10
J2C 10

-5V
J1A 8
J1B 8
J1C 8

+5V
J1A 9
J1B 9
J1C 9
J1A 10
J1B 10
J1C 10

-48 RETURN
J2A29
J2B29
J2C29

+12V
J1A 13
J1B 13
J1C 13

-48V RETURN
J1A 29
J1B 29
J1C 29

-12V
J2A 14
J2B 14
J2C 14

ALARM
J1A 4
J1B 4
J1C 4

-12V
J1A 14
J1B 14
J1C 14

-48V
J2A28
J2B28
J2C28
J2A 1
J2B 1
J2C 1
J2A32
J2B32
J2C32

-RING
J1A30
J1B30
J1C30

+RING
J1A 31
J1B 31
J1C 31

-48V
J1A 28
J1B 28
J1C 28
J1A 1
J1B 1
J1C 1
J1A 32
J1B 32
J1C 32

0247988

ALARM
P1 2
5V
RETURN
P1 3
P2 2
P3 3
C1
0.01-50V
12V
RETURN
C2
0.01-50V
P3 6

-48V
RETURN
C3
0.01-50V
P1 1
P2 1
P3 1
P3 2
P3 4
P3 5

FIG. 19

0247988

FIG. 20

12V RETURN
C12
10-20V TAN
+12V
C13
10-20V TAN
-12V
J7A 11
J7B 11
J7C 11
J7A 12
J7B 12
J7C 12
12V RETURN
J6A 11
J6B 11
J6C 11
J6A 12
J6B 12
J6C 12
5V RETURN
C14
10-20V TAN
+5V
C15
10-20V TAN
-5V
J7A 6
J7B 6
J7C 6
J7A 7
J7B 7
J7C 7
5V RETURN
J6A 6
J6B 6
J6C 6
J6A 7
J6B 7
J6C 7
FLT BUS
J7A 5
J7B 5
J7C 5
+5V
J7A 9
J7B 9
J7C 9
J7A 10
J7B 10
J7C 10
FLT BUS
J6A 5
J6B 5
J6C 5
-5V
J7A 8
J7B 8
J7C 8
-5V
J6A 8
J6B 8
J6C 8
+12V
J7A 13
J7B 13
J7C 13
-48V RETURN
J7A 29
J7B 29
J7C 29
+12V
J6A 13
J6B 13
J6C 13
ALARM
J7A 4
J7B 4
J7C 4
-12V
J7A 14
J7B 14
J7C 14
ALARM
J6A 4
J6B 4
J6C 4
-RING
J7A 30
J7B 30
J7C 30
-48V
J7A 28
J7B 28
J7C 28
J7A 1
J7B 1
J7C 1
J7A 32
J7B 32
J7C 32
-RING
J6A 30
J6B 30
J6C 30
+RING
J7A 31
J7B 31
J7C 31
+RING
J6A 31
J6B 31
J6C 31

0247988

FIG. 21

12V RETURN

J5A 11
J5B 11
J5C 11
J5A 12
J5B 12
J5C 12

C16 10-20V TAN +12V

C17 10-20V TAN -12V

5V RETURN

J5A 6
J5B 6
J5C 6
J5A 7
J5B 7
J5C 7

C18 10-20V TAN +5V

C19 10-20V TAN -5V

FLT BUS

J5A 5
J5B 5
J5C 5

+5V

J6A 9
J6B 9
J6C 9
J6A 10
J6B 10
J6C 10

-5V

J5A 8
J5B 8
J5C 8

+5V

J5A 9
J5B 9
J5C 9
J5A 10
J5B 10
J5C 10

-48V RETURN

J6A29
J6B29
J6C29

+12V

J5A 13
J5B 13
J5C 13

-48V RETURN

J5A29
J5B29
J5C29

-12V

J6A 14
J6B 14
J6C 14

ALARM

J5A 4
J5B 4
J5C 4

-12V

J5A 14
J5B 14
J5C 14

-48V

J6A 28
J6B 28
J6C 28
J6A 1
J6B 1
J6C 1
J6A 32
J6B 32
J6C 32

-RING

J5A 30
J5B 30
J5C 30

+RING

J5A 31
J5B 31
J5C 31

-48V

J5A28
J5B28
J5C28
J5A 1
J5B 1
J5C 1
J5A 32
J5B 32
J5C 32

12V RETURN
J4A 11
J4B 11
J4C 11
J4A 12
J4B 12
J4C 12
5V RETURN
J4A 6
J4B 6
J4C 6
J4A 7
J4B 7
J4C 7
FLT BUS
J4A 5
J4B 5
J4C 5
-5V
J4A 8
J4B 8
J4C 8
+12V
J4A 13
J4B 13
J4C 13
ALARM
J4A 4
J4B 4
J4C 4
-RING
J4A 30
J4B 30
J4C 30
+RING
J4A 31
J4B 31
J4C 31
+5V
J4A 9
J4B 9
J4C 9
J4A 10
J4B 10
J4C 10
-48V RETURN
J4A 29
J4B 29
J4C 29
-12V
J4A 14
J4B 14
J4C 14
-48V
J4A 28
J4B 28
J4C 28
J4A 1
J4B 1
J4C 1
J4A 32
J4B 32
J4C 32

FIG. 22

12V
RETURN
C20
10-20V TAN
+
+12V
C21
10-20V TAN
+
-12V
12V
RETURN
J10A 11
J10B 11
J10C 11
J10A 12
J10B 12
J10C 12
5V
RETURN
C22
10-20V TAN
+
+5V
C23
10-20V TAN
+
-5V
5V
RETURN
J10A 6
J10B 6
J10C 6
J10A 7
J10B 7
J10C 7
FLT
BUS
J10A 5
J10B 5
J10C 5
+5V
J10A 9
J10B 9
J10C 9
J10A 10
J10B 10
J10C 10
-5V
J10A 8
J10B 8
J10C 8
+12V
J10A 13
J10B 13
J10C 13
-48V
RETURN
J10A29
J10B29
J10C29
ALARM
J10A 4
J10B 4
J10C 4
-12V
J10A14
J10B14
J10C14
-RING
J10A30
J10B 30
J10C 30
-48V
J10A28
J10B28
J10C28
J10A 1
J10B 1
J10C 1
J10A32
J10B32
J10C32
+RING
J10A 31
J10B31
J10C 31

FIG. 23

0247988

12V RETURN
C24 10-20V TAN
+12V
C25 10-20V TAN
-12V
J9A 11
J9B 11
J9C 11
J9A 12
J9B 12
J9C 12
5V RETURN
C26 10-20V TAN
+5V
C27 10-20V TAN
-5V
J9A 6
J9B 6
J9C 6
J9A 7
J9B 7
J9C 7
FLT BUS
J9A 5
J9B 5
J9C 5
+5V
J9A 9
J9B 9
J9C 9
J9A 10
J9B 10
J9C 10
-5V
J9A 8
J9B 8
J9C 8
+12V
J9A 13
J9B 13
J9C 13
-48V RETURN
J9A29
J9B29
J9C29
ALARM
J9A 4
J9B 4
J9C 4
-12V
J9A 14
J9B 14
J9C 14
-RING
J9A 30
J9B 30
J9C 30
-48V
J9A28
J9B28
J9C28
J9A 1
J9B 1
J9C 1
J9A32
J9B32
J9C32
+RING
J9A 31
J9B 31
J9C 31

FIG. 24

12V RETURN
J8A 11
J8B 11
J8C 11
J8A 12
J8B 12
J8C 12
5V RETURN
J8A 6
J8B 6
J8C 6
J8A 7
J8B 7
J8C 7
FLT BUS
J8A 5
J8B 5
J8C 5
-5V
J8A 8
J8B 8
J8C 8
+12V
J8A 13
J8B 13
J8C 13
ALARM
J8A 4
J8B 4
J8C 4
-RING
J8A 30
J8B 30
J8C 30
+RING
J8A 31
J8B 31
J8C 31
+5V
J8A 9
J8B 9
J8C 9
J8A 10
J8B 10
J8C 10
-48V RETURN
J8A29
J8B29
J8C29
-12V
J8A 14
J8B 14
J8C 14
-48V
J8A28
J8B28
J8C28
J8A 1
J8B 1
J8C 1
J8A32
J8B32
J8C32

FIG. 25

12V
RETURN
J15A 11
J15B 11
J15C 11
J15A 12
J15B 12
J15C 12
C28
10-20V TAN
+12V
C29
10-20V TAN
-12V
5V
RETURN
J15A 6
J15B 6
J15C 6
J15A 7
J15B 7
J15C 7
C30
10-20V TAN
+5V
C31
10-20V TAN
-5V
FLT
BUS
J15A 5
J15B 5
J15C 5
-5V
J15A 8
J15B 8
J15C 8
+12V
J15A 13
J15B 13
J15C 13
ALARM
J15A 4
J15B 4
J15C 4
-RING
J15A30
J15B30
J15C30
+RING
J15A
J15B
J15C
+5V
J15A 9
J15B 9
J15C 9
J15A 10
J15B 10
J15C 10
-48V
RETURN
J15A29
J15B29
J15C29
-12V
J15A 14
J15B 14
J15C 14
-48V
J15A28
J15B28
J15C28
J15A 1
J15B 1
J15C 1
J15A32
J15B32
J15C32

FIG. 26

12V
RETURN
J12A 11
J12B 11
J12C 11
J12A 12
J12B 12
J12C 12
C32
10-20V TAN
-12V
C33
10-20V TAN
-12V
5V
RETURN
J12A 6
J12B 6
J12C 6
J12A 7
J12B 7
J12C 7
C34
10-20V TAN
+5V
C35
10-20V TAN
-5V
FLT
BUS
J12A 5
J12B 5
J12C 5
+5V
J12A 9
J12B 9
J12C 9
J12A 10
J12B 10
J12C 10
-5V
J12A 8
J12B 8
J12C 8
+12V
J12A 13
J12B 13
J12C 13
-48V
RETURN
J12A29
J12B29
J12C29
ALARM
J12A 4
J12B 4
J12C 4
-12V
J12A 14
J12B 14
J12C 14
-RING
J12A 30
J12B 30
J12C 30
-48V
J12A28
J12B28
J12C28
J12A 1
J12B 1
J12C 1
J12A32
J12B32
J12C32
+RING
J12A 31
J12B 31
J12C 31

FIG. 27

12V RETURN
C36 10-20V TAN
+12V
C37 10-20V TAN
-12V
5V RETURN
C38 10-20V TAN
+5V
C39 10-20V TAN
-5V
12V RETURN
J18A 11
J18B 11
J18C 11
J18A 12
J18B 12
J18C 12
C40 10-20V TAN
-12V
C41 10-20V TAN
-12V
5V RETURN
J18A 6
J18B 6
J18C 6
J18A 7
J18B 7
J18C 7
C42 10-20V TAN
+5V
C43 10-20V TAN
-5V
FLT BUS
J18A 5
J18B 5
J18C 5
+5V
J18A 9
J18B 9
J18C 9
J18A 10
J18B 10
J18C 10
-5V
J18A 8
J18B 8
J18C 8
+12V
J18A 13
J18B 13
J18C 13
-48V RETURN
J18A29
J18B29
J18C29
ALARM
J18A 4
J18B 4
J18C 4
12V
J18A 14
J18B 14
J18C14
-RING
J18A 30
J18B 30
J18C 30
-48V
J18A28
J18B28
J18C28
J18A 1
J18B 1
J18C 1
J18A32
J18B32
J18C32
+RING
J18A 31
J18B 31
J18C 31

FIG. 28

170
TX 1
TX 2
TX 3
TX 4
RX 1
RX 2
RX 3
RX 4
160
TX 1 QCP
TX 2 QCP
TX 3 QCP
TX 4 QCP
HI
LO
SW1
SW2
SW3
SW4
MUX
152
AGGREGATE LOOPBACK
F.O. EMITTER
166
154
160
RX 1 QCP
RX 2 QCP
RX 3 QCP
RX 4 QCP
DEMUX
156
162
168
158


FIG. 29

FIG. 30

| | VCC | V- | ⏚ | CHASSIS GND symbol | ▽ |
|---|---|---|---|---|---|
| REF DES | +5V | -5V | 5V RETURN | CHASSIS GND | 12V RETURN |
| U1 | 24 | | 12 | | |
| U2 | 16 | | 8 | | |
| U3 | 14 | | 7 | | |
| U4 | | | | | |
| U5 | 14 | | 7 | | |
| U6 | 16 | | 8 | | |
| U7 | 16 | | 8 | | |
| U8 | 16 | | 8 | | |
| U9 | 16 | | 8 | | |
| U10 | 16 | | 8 | | |
| U11 | 24 | | 12 | | |
| U12 | | | | | |
| U13 | 16 | | 8 | | |
| U14 | 16 | | 8 | | |
| U15 | 14 | | 7 | | |
| U16 | 1 | 8 | 5 | | |
| U17 | 1 | 8 | 5 | | |
| U18 | 16 | | 8 | | |
| U19 | | | | | |
| U20 | 16 | | 8 | | |
| U21 | 16 | | 8 | | |
| U22 | 14 | | 7 | | |
| U23 | 14 | | 7 | | |
| U24 | | | | | |
| U25 | | | | | |
| U26 | | | | | |
| U27 | | | | | |
| U28 | | | | | |

0247988

U15
L508
4
5
6
&
9
10
8
12
13
11
5V RETURN
U22
L504
3
1
4
9
8
11
10
SPARES
VCC
R53
10K
U5
AL574
C1
R


FIG. 31

PIA 13
PIB 13
PIC 13
F3
+12
PIA 11
PIB 11
PIC 11
PIA 12
PIB 12
PIC 12
+
C75
10-20V
TAN 10%
C76
0.1-50V
12V
RETURN


FIG. 32

PIA 1
PIA 2
PIA 3
PIA 15
PIA 20
PIA 25
PIA 26
PIA 27
PIA 32
PIB 1
PIB 2
PIB 3
PIB 15
PIB 20
PIB 25
PIB 26
PIB 27
PIB 32
PIC 1
PIC 2
PIC 3
PIC 15
PIC 16
PIC 17
PIC 18
PIC 19
PIC 20
PIC 21
PIC 22
PIC 23
PIC 24
PIC 25
PIC 26
PIC 27
PIC 32
CHASSIS GND

FIG. 33

PIA 4
PIA 14
PIA 28
PIA 29
PIA 30
PIA 31
PIB 4
PIB 14
PIB 28
PIB 29
PIB 30
PIB 31
PIC 4
PIC 14
PIC 28
PIC 29
PIC 30
PIC 31

FLOATED PINS

FIG. 34

0247988

VCC
C68-74
0.1-50V
C54-67
0.01-50V
C53
0.1-50V
+
C52
10-20V
V-
C51
0.1-50V
C50
10-20V
+
F2
F1
PIA 9
PIB 9
PIC 9
PIA 10
PIB 10
PIC 10
PIA 8
PIB 8
PIC 8
PIA 6
PIB 6
PIC 6
PIA 7
PIB 7
PIC 7

FIG. 35

FIG. 36A

VCC
R3 10K
U20 LS175
R C1 1D
U21 LS175
R C1 1D
VCC
U4 1 2 3 4 5 6 7 8 9 10
U14 HC157
EN G1
1 MUX
1 MUX
1 MUX
1 MUX
A A2-4
B A3-4
C A2-5
D A3-5
5V RETURN
VCC
R28 887
CR1 RED
U3 LS14
U3 LS14
R27 1K
FAULT
PIA 5
PIB 5
PIC
Q2 PN3568
5V RETURN

FIG. 36B

VCC
VCC
VCC
R20
6.65K
R16
1K
R14
10K
U13
LS221
C28
330 PF-50V
5%
VCC
VCC
R17
715
R21
10K
U6
LS221
5%
50 NS
5V
RETURN
VCC
R13
3.3K
U11
DP8343
OE
OC
RD
RDIS
CLK
DCONT
DATA
+AMP
−AMP
D1
D2
D3
D4
D5
D6
D7
D8
DA
SER
DCLK
RACT
ERROR
D2-7
Y
U22
LS04
US
ALS74
D1-7
Z
5V RETURN

U16
D53692
D2-3
A
B
2
IN
3
INB
6
INC
7
IND
4
MODE
CAPA
OUTA
CAPB
OUTB
CAPC
OUTC
CAPD
OUTD
16
15
13
14
12
11
9
10
C35
20PF-50V CER 5%
C36
20PF-50V CER 5%
C37
20PF-50V CER 5%
C38
20PF-50V CER %
5V RETURN
+12
LOOPBACK
SW1
3
2
1
NORMAL
12V RETURN
CR11
1N4148
K1
+
-
16
12V RETURN
+12
LOOPBACK
SW2
3
2
1
NORMAL
12V RETURN
CR12
1N4148
K1
+
-
16
12V RETURN

FIG. 37A

0247988

PIA16
TX1+
FB1
PIB16
TX1-
FB2
PIA17
TX2+
FB3
PIB17
TX2-
FB4
PIA21
RX1+
FB5
PIB21
RX1-
FB6
PIA22
RX2+
FB7
PIB22
RX2-
FB8
8
4
6
K1
9
13
11
K1
8
4
6
K2
9
13
11
K2
7
3
5
K1
10
14
12
K1
7
3
5
K2
10
14
12
K2

FIG. 37B

0247988

TX1+
P2 1
TX1-
P2 2
TX2+
P2 3
TX2-
P2 4
VCC
R22
3.3K
U9
L5120
4
3
2
1
5
+IN
TERM
-IN
OFFSET
STROBE
OUT
RES
7
6
E
A3-7
SW6
13
1
BALANCED
14
BALANCED
U9
L5120
12
13
14
15
11
+IN
TERM
-IN
OFFSET
STROBE
OUT
RES
9
10
F
A3-7
SW6
2
3
BALANCED
12
UNBALANCED
RX1+
P2 9
RX1-
P2 10
RX2+
P2 11
RX2-
P2 12


FIG. 37C

U17
D53692
D2-3
C
D2-3
D
2
IN
3
INB
6
INC
7
IND
4
MODE
CAPA
OUTA
CAPB
OUTB
CAPC
OUTC
CAPD
OUTD
16
15
13
14
12
11
9
10
C39
20PF-50V CER 5%
C40
20PF-50V CER 5%
C41
20PF-50V CER 5%
C42
20PF-50V CER %
5V RETURN
+12
LOOPBACK
SW3
3
2
1
NORMAL
12V RETURN
1N4148
+
K1
-
1
16
12V RETURN
+12
LOOPBACK
SW4
3
2
1
NORMAL
12V RETURN
CR13
1N4148
+
K
-
1
16
12V RETURN

FIG. 38A

PIA18
TX3+
FB9
PIB18
TX3-
FB10
PIA19
TX4+
FB11
PIB19
TX4-
FB12
PIA23
RX3+
FB13
PIB23
RX3-
FB14
PIA24
RX4+
FB15
PIB24
RX4-
FB16
8
4
6
K3
7
3
5
K3
9
13
11
K3
10
14
12
K3
8
4
6
K4
7
3
5
K4
9
13
11
K4
10
14
12
K4


FIG. 38B

TX3+
P2 5
TX3-
P2 6
TX4+
P2 7
TX4-
P2 8
VCC
R24
3.3K
U10
L5120
+IN
TERM
OUT
-IN
OFFSET
STROBE RES
G
A3-7
SW6
BALANCED
10
BALANCED
U10
L5120
H
A3-7
SW6
BALANCED
8
UNBALANCED
RX3+
P2 13
RX3-
P2 14
RX4+
P2 15
RX4-
P2 16

FIG. 38C

247988

FIG. 39A
R45
47.5
C14
10-20V
TAN 10%
C15
0.01-50V
C13
10-20V
TAN 10%
C12
0.01-50V
R44
10
U27
NE592
U26
HFBR-2404
R41
100
C29
0.1-50V
CER 10%
C30
0.1-50V
CER 10%
C32
0.1-50V
CER 10%
V+
V-
C31
470 PF-33V
POLY 2.5%
R42
1K
C33
0.1-50V
CER
10%
R43
1K
C44
10-20V
TAN 10%
C43
0.01-50V
R46
1K

FIG. 39B

VCC
L3
22UH
L2
22UH
L1
22UH
U
AI-8
C16
10-20V
TAN 10%
C18
0.01-50V
C9
0.01-50V
C10
10-20V
TAN 10%
5V RETURN
TP1
R49
27.4K
U28
LM360
2
3
8
6
7
4
5
R48
27.4K
V
AI-7
V-
L7
22UH
L4
22UH
R47
1K
C10
10-20V
TAN 10%
C45
0.01-50V
5V RETURN

0247988

FIG. 40A

U23
LS125
EN
A2-8
W
U23
LS126
VCC
R51
3.3K
SW5
NORMAL
AL
AGGREGATE
LOOPBACK
5V
RETURN
A3-3
Z
U1
DP8342
X1
X2
D1
D2
D3
D4
D5
D6
D7
D8
OE
LOAD
AUTO
OPAR
RST
200 NS
D0
DDLY
CLKO
BCLK
XACT
RFULL
R1
3.3K
R50
4.75K
U22
LS04
A3-3
Y
R23
3.3K
R11
2K
R10
10K
C24
100PF-50V
5%
R
CX
RX/CX
50 NS
U2
HC4040
CT.0
CT
U18
HC4040
U3
LS14
U15
LS08

247988

D3-6
V
VCC
VCC
VCC
VCC
VCC
R4
1K
R15
6.65K
R5
10K
U13
LS221
C21
15PF-50V
5%
R7
10K
C27
330PF-50V
5%
R
CX
RX/CX
150 NS
Y1
28MHZ
R2
121
U8
LS175
R
C1
1D
U7
LS175
R
C1
1D
D2-4
E
D3-4
F
D2-5
G
D3-5
H
VCC
R6
10K
CR2
1N4148
C20
10-20V
TAN 10%
U3
LS14
U3
LS14
5V
RETURN


FIG. 40B

0247988

DI-6
U
R8
182.0
L5
22UH
C11
0.01-50V
C19
10-20V
TAN 10%
5V RETURN
C25
0.1-50V
CER 10%
C22
0.1-50V
CER 10%
R12
221
5
1
2
4
3
U24
MC10116
C4
0.1-50V
CER 10%
U24
MC10116
13
16
15
12
11
14
R26
274
DI-7
W
R18
221
R29
825.0
C5
0.01-
50V
R30
1K
R31
1K
R32
1K
R33
1K
R34
100
R35
100
3.7V
U24
MC10116
10
9
6
7
8
C6
0.1-50V
CER 10%
5V RETURN


FIG. 41A

R9
162
R19
27.4
C3
0.01-50V
+
C17
10-20V
TAN
10%
2 6 7
U12
HFBR-1404
3
R25
162
SW7
5V RETURN
4 CW
2
3 NORMAL
CR3
IN4148
CR4
IN4148
CR5
IN4148
O1
MP56515
O4
MP
56515
CR6
IN4148
CR7
IN4148
CR8
IN4148
C1
0.001-50V
CR9
IN5712
CR10
IN5712
C2
0.001-50V
L6
22UH
VCC
R40
562
O3
2N4400
R36
274
R37
8.25
R38
33.2
SW7
60MA
HIGH
POWER
6
1
5
LOW
POWER
15MA
U25
LM313
1.22V
C7
0.1-50V
CER %
+
C8
10-20V
TAN
10%
C26
0.1-50V
CER 10%
R39
274

FIG. 41B

0247988

FIG. 42 A
200
203
200
201
203
C37
042
F81
070
F85
070
F82
070
F86
070
F83
070
F87
070
F84
070
F88
070
F89
070
F813
070
F810
070
F814
070
F811
070
F815
070
F812
070
F816
070
C36
042
C70
028
C38
042
CR11
001
C41
CR12
C40
CR14
BAL.
C71
026
C42
042
CR13
001
203
210
201
200
215
FAULT
217
P2
1
16
AL
1
2
3
4
227
221
221
227


FIG. 42D

0247988

FIG. 42B

200
201
200
FIBER MATE
DIG. MUX
203
220
200
201

201
219
213
201
223
223
223
CR1
P2
053
1
16
SW5
SW4
SW3
SW2
SW1
C22
C4
U24
067
R28
C6
R34
R35
R18
R39
R36
R12
C12
C5
R30
R31
R32
R33
L2
C9
L1
C25
R8
R26
R29
C7
R37
R38
C11
C19
002
C13
002
C10
002
C16
002
C18
L3
U28
055
R49
R46
R48
R47
C32
C30
R44
U27
057
R50
C44
002
C45
L4
R51
U23
032
U22
029
C67
C66
L7
C43
C34
002
C33
R43
R25
R9
CR3
CR4
CR5
C1
L5
R19
CR9
CR10
01
04
SW7
C2
C3
CR6
CR7
CR8
C17
002
L6
R40
C26
C29
C45
C15
03
C8
002
025
066
025
R42
R41
C31
C14
002
U12
060
U26
059
203
230
232
234
201

FIG. 42C

FIBER MATE DIG MUX
SW1
SW2
SW3
SW4
SW5
SW6
SW7
TP1
BAL
P1
P2
16
32
2-40490-0134 COMPONENT SIDE

FIG. 43

FIG. 44

0247988

FIG. 45

PC BOARD
2-40490-0134
ADC TELECOMMUNICATIONS
2-40490-0134 SOLDER SIDE

FIG. 46

0247988

FIG. 47

FIG. 48

2-40490-0134 PAD LAYER

FIG. 49

0247988

300
110
304
306

FIG. 50

110
304
312
1
2
3
4
320
+
-
TX
RX
314

FIG. 51

0247988

SDL CONNECTOR
TX 1
TX 2
TX 3
TX 4
RX 1
RX 2
RX 3
RX 4
SWITCH1
RED LED +
YELLOW LED-
RED LED+
YELLOW LED-
320
TX 1
RX 1
TX 2
RX 2
TX 3
RX 3
TX 4
RX 4
SIGNAL GROUND
CHASSIS GROUND
2
14
3
16
4
19
5
13
24
23
15
18
20
11
6
25
7
1


FIG. 52